(19) Europäisches Patentamt
European Patent Office
Office européen des brevets

(11) EP 1 255 287 A1

(12) **EUROPEAN PATENT APPLICATION**
published in accordance with Art. 158(3) EPC

(43) Date of publication:
**06.11.2002 Bulletin 2002/45**

(21) Application number: **01936972.7**

(22) Date of filing: **12.06.2001**

(51) Int Cl.[7]: **H01L 21/304**, H01L 21/306, B08B 3/10

(86) International application number:
**PCT/JP01/04962**

(87) International publication number:
**WO 02/027776 (04.04.2002 Gazette 2002/12)**

(84) Designated Contracting States:
**DE FR GB**

(30) Priority: **28.09.2000 WOPCT/JP00/06694**

(71) Applicants:
- **MITSUBISHI DENKI KABUSHIKI KAISHA Tokyo 100-8310 (JP)**
- **SPC Electronics Corporation Chofu-shi, Tokyo 182-8602 (JP)**

(72) Inventors:
- **NODA, Seiji, c/o MITSUBISHI DENKI KABUSHIKI KAISHA Chiyoda-ku, Tokyo 100-8310 (JP)**
- **HORIBE, Hideo, c/o MITSUBISHI DENKI K. K. Chiyoda-ku, Tokyo 100-8310 (JP)**
- **MIYAMOTO, Makoto,c/o MITSUBISHI DENKI K K Chiyoda-ku, Tokyo 100-8310 (JP)**
- **OYA, Izumi,c/o MITSUBISHI DENKI KABUSHIKI KAISHA Chiyoda-ku, Tokyo 100-8310 (JP)**
- **KUZUMOTO, Masaki, c/o MITSUBISHI DENKI K K Chiyoda-ku, Tokyo 100-8310 (JP)**

(74) Representative: **Sajda, Wolf E., Dipl.-Phys. et al MEISSNER, BOLTE & PARTNER Widenmayerstrasse 48 80538 München (DE)**

# (54) SUBSTRATE PROCESSING METHOD, AND APPARATUS THEREFOR

(57) There is provided a process for treating a substrate by removing organic pollutant on the surface of the substrate using mixed gas of wet ozone-containing gas and basic gas, wherein the introduction amount of basic gas is controlled, thereby achieving complete prevention of corrosion of metal wiring previously formed on the substrate, and an apparatus therefor. The apparatus for treating a substrate of the present invention comprises a substrate heating means (4) for keeping the substrate at temperature higher than room temperature, a wetting means (7) for obtaining wet ozone-containing gas, a supplying means (5) for supplying wet ozone-containing gas to substance to be treated on the substrate surface, a gas sending tube (8) for connecting the wetting means and the supplying means, a supplying means (18) for supplying basic gas-containing gas to substance to be treated on the substrate surface and a gas heating means (9) for heating each of the wetting means, the supplying means and the gas sending tube to temperature equal to or higher than that of the substrate.

FIG. 1

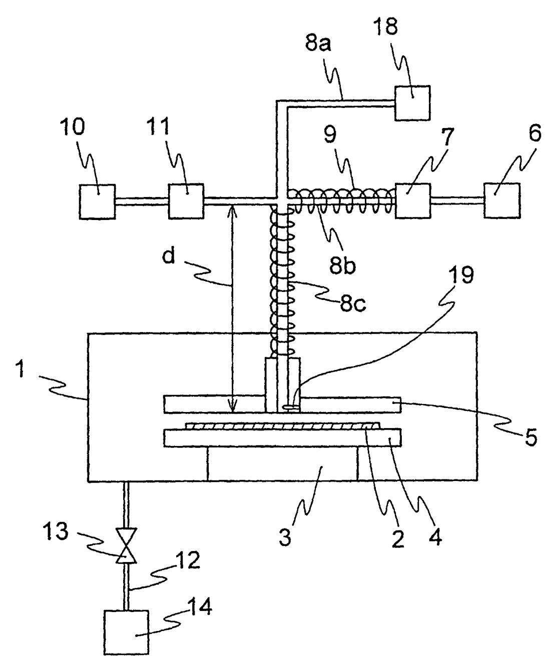


EP 1 255 287 A1

**Description**

TECHNICAL FIELD

The present invention relates to a process for treating a substrate by removing, for example, a photoresist film and undesirable organic or inorganic compounds from the surface of an object to be treated in micro-processing steps including fabrication steps of a semiconductor such as IC and LCI; an LCD; and a printed substrate, and an apparatus therefor.

BACKGROUND ART

In micro-processing steps including fabrication steps of a semiconductor device such as IC or LSI, a photosensitive organic polymer compound is applied to a semiconductor substrate of silicon or a glass substrate, and the substrate is exposed to ultraviolet ray having a specific wavelength through a photomask with a prescribed circuit pattern, followed by development using an aqueous alkaline solution to form a photoresist pattern on the substrate. Further, film formation by CVD, sputtering and the like; etching by a chemical agent or RIE (reactive ion etching); and diffusion by heating or ion-implantation of impurity elements is carried out. Then, the photoresist film on the substrate which has been subjected to a series of treatments is removed by means of chemical treatment. Generally, such a series of operations as applying a photoresist and removing the photoresist after various treatments is repeated more than once in the fabrication steps of LSI and the like.
A variety of methods have been employed for removing a photoresist film. It is necessary to remove photoresist film completely since incomplete removal of the photoresist film may have bad influence on the subsequent steps. In particular, complete removal is required in recent cases where the integration degree of a semiconductor circuit is increased and the line width of a semiconductor circuit to be formed is made thin, since the residue of the photoresist film causes a more serious problem than in the case of a low integration degree circuit. Generally, a photoresist film is removed according to a wet method using a chemical solution or a dry method using oxygen plasma or the like.
In the wet method for removing a photoresist film, sulfuric acid of high concentration has been generally used, to which hydrogen peroxide is mixed in order to increase the oxidation capability of sulfuric acid. Similarly, a special resist treatment liquid (30 % of dimethyl sulfoxide solution and 70 % of monoethanol amine solution) has been used in LCD fabrication steps. On the other hand, a chemical solution of permanganic acid and the like has been used in the removal of smear on a printed substrate. In case of removing a photoresist film and undesirable adhering substances using these chemical solutions, removal of adhering chemical solution after the removal and washing of residue and other adhering substances with ultra pure water are widely carried out. In any method, it is necessary to use an expensive and environmentally harmful chemical solution in a large quantity.
As an environmentally friendly process for treating a substrate, a process for removing undesirable adhering substances such as organic matters by using ozone gas has been proposed.
Japanese Unexamined Patent Publication No. 219926/1999 discloses a method for removing organic pollutant from a semiconductor substrate by mixed gas containing steam, ozone gas and a substance working as an OH radicalscavenger. In a conventional process using ozone and water, solubility of ozone in a mixed layer of water and ozone formed on a surface of a substrate is restricted in a high temperature range, resulting in decrease of washing effect when the substrate temperature is increased for the purpose of improving treatment speed. The method of this patent publication is illustrated in Fig. 23 and comprises using a quartz tank 101 for storing a liquid and an ozone diffusion apparatus 102 positioned at the bottom of the tank. The wet ozone produced by diffusing ozone to a liquid is reacted on the object substrate 103 to be treated installed above the quartz tank. According to the method, the mixed layer on the surface of the substrate can be made thin and an ozone component having a short life and high reactivity can easily reach the wafer surface, removal efficiency approximating 100 %.
Japanese Unexamined Patent Publication No. 152270/1993 discloses a method for reacting ozone-containing gas passed through a treatment liquid on an object to be treated which is present on the surface of a substrate. The method of this patent publication is illustrated in Fig. 24. A treatment chamber 110 comprises a substrate setting stand 111, a substrate 112, a gas dispersion plate 118, holes 119 and an ultrapure water supply nozzle 121. In the treatment chamber 110 are installed an ozone decomposition apparatus 120 through a gas discharge tube 113, an oxygen storage tank 115, an ozone generator 114 and a gas contact apparatus 116 through an ozone-containing gas supply tube 117.
After ozone-containing gas is wetted, for example, by passing the gas through ultrapure water, the resulting ozone-containing gas is introduced to the surface of the substrate 112 to be treated. The surface of the substrate is gradually wetted by the wet ozone-supply gas and a thin film of water is formed on the substrate surface to make the removal of an organic film possible without heating the substrate.
However, in such processes using wet ozone gas, it is feared that acidic substance produced at the time of oxidation decomposition of the organic pollutant by ozone are ionized by a slight amount of water in a thin film-like state formed on the substrate surface and the substrate shows strong acidity. As described in the following examples, it has been found for the first time that wiring metal such as aluminum is dissolved in case of using wet ozone gas in process where a metal such as aluminum having low acid resistance are exposed, according to the experimental investigations of the present inventors. Further, it has been made clear that the main cause of the metal dissolution is that the pH on the substrate has changed to about pH 2 owing to the acidic substance produced by oxidation and decomposition of the organic pollutant.

According to ATLAS OF ELECTROCHEMICAL EQUILIBRIA IN AQUEOUS SOLUTIONS (Pergamon Press 1966) p. 171, aluminum, which has been widely used as a wiring material in the field of, for example, semiconductor or LCD fabrication, cannot form a stable oxide in ozone-containing water at pH <4 or pH >9 and exists in ionic state. In other words, there is the risk that aluminum dissolves in a solution under a strong acidic or alkaline condition.

Japanese Unexamined Patent Publication No. 133535/1988 discloses a method which comprises washing an object to be washed with a washing solution which shows acidity by water addition and then diluting the washing solution without increasing the hydrogen ion concentration. Dilution with a buffer solution such as a phosphoric acid solution prevents generation of strong acid and prevents aluminum wiring from corroding and disconnecting.

Japanese Unexamined Patent Publication No. 166724/1991 discloses a method which comprises incinerating a photoresist formed on a semiconductor substrate either with oxygen plasma or in ozone atmosphere and then washing with pure water. In this case, since washing is carried out with water having a high purity and water is discharged immediately, the surface of the substrate can be kept neutral even if an acid is produced attributed to residual chlorine. Corrosion of an aluminum alloy, which is a wiring material, is prevented according to this method.

Those methods for preventing corrosion of wiring are effective in the step of washing the residues of the previous step. However, the pH on the surface of the substrate cannot be kept approximately neutral in a system where organic polluting substance is gradually oxidized and decomposed and acidic substance is gradually produced as in the process using the wet ozone gas.

Regarding the method for removing organic pollutant from the surface of a substrate using ozone, there is a method for cleaning a substrate by introducing a chemical substance other then ozone into the system.

Japanese Unexamined Patent Publication No. 109686/1993 discloses a cleaning method capable of removing organic substances and adhering substances on the wafer surface by supplying steam, ozone gas and ammonia gas. Conventionally, a mixed solution of aqueous ammonia and aqueous hydrogen peroxide (composition ratio: aqueous ammonia : aqueous hydrogen peroxide : water = 1 : 1 : 5) and the like have been used for removing adhering substance on the surface of a substrate. However composition of the chemical solution is changed by evaporation or reaction and washing effect is decreased with time. According to this method, stable washing effect can be obtained by using ozone as an oxidizer in place of hydrogen peroxide. Further, since steam is generated by burning mixed gas of oxygen and hydrogen, fine steam can be produced in the vapor phase to make the method suitable for washing a substrate bearing a fine pattern. The composition ratio of ammonia gas : ozone gas : steam is the optimum if it is (1/20 to 1/5) : (1/6 to 1/4) : 1.

Lecture No. 28p-YH-2, Lecture Resume, p. 795 of 47th Applied Physics Spring Assembly discloses a high speed resist removal method using an acetic acid film saturated with ozone. Fig. 25 illustrates this method in which acetic acid 122 is supplied to a tank 123 for rinsing and supplied to a wafer 125 through a quartz wool sheet 124 and ozone 127 is supplied from an ozone buffer 126.

A substrate 125 coated with 1 μm-thick resist is immersed in acetic acid of room temperature (purity: 99.7 %) saturated with 200 mg/L of ozone gas and the substrate is immediately pulled out. A 50 μm-thick liquid film is fed to the surface of the substrate through the glass wool 124 and the resist is completely peeled within a minute.

## DISCLOSURE OF THE INVENTION

The methods for treating a substrate disclosed in Japanese Unexamined Patent Publication No. 219926/1999 and Japanese Unexamined Patent Publication No. 152270/1993 describe that using wet ozone makes it possible to form a thin film of a treatment liquid on the surface of a substrate and to carry out high speed treatment without inhibiting ozone diffusion. However, in such processes using wet ozone gas, acidic substance (carboxylic acids and the like) produced at the time of oxidation decomposition of organic pollutant by ozone are ionized by a slight amount of water in a thin film-like state formed on the surface of the substrate and the substrate assumes high acidity, therefore causing wiring having low acid resistance to be corroded and dissolved in the solution. Even if organic pollutant is completely removed, properties as a semiconductor device are lost, which means that the method cannot be applied to a practical process. In order to make the above substrate treating methods using wet ozone-containing gas practically usable even for a substrate comprising a wiring of metal having low acid resistance, it is an indispensable condition to prevent the corrosion of wiring caused by the removal of organic pollutant. However, there is no practical application of the method at present.

Generally, the surface of a substrate is kept neutral by introducing an alkaline substance in the same amount as that of the acidic substance into the system. In other words, the wiring corrosion can be prevented by introducing an alkaline substance in the same amount as that of the acidic substance produced by the oxidation decomposition of organic pollutant by ozone. However, in the washing method with steam, ammonia and ozone gas as disclosed in Japanese Unexamined Patent Publication No. 109686/1993, attention is paid only to the ratio of the oxidizer (ozone) to the reducing agent (ammonia) contained in the washing gas, and therefore excess ammonia is introduced as compared with the amount of the acidic substance produced by oxidation decomposition of organic pollutant by ozone.

In addition, even if the acidic substance is produced, hydrogen ion concentration is not increased and no acidity is shown unless the acidic substance is ionized in the treatment liquid. For example, carboxylic acids such as acetic acid prevent ionization of acidic substance produced by oxidation decomposition of organic pollutant by ozone and the pH is hardly changed. However, in the resist removal method by an acetic acid solution film saturated with ozone as described in Lecture No. 28p-YH-2, Lecture Resume, p. 795 of 47th Applied Physics Spring Assembly, a large amount of high purity acetic acid must be used and thus the method is environmentally harmful and not preferable. The Lecture Resume describes that a 50 μm-thick liquid film was formed on a substrate and a 1 μm-thick resist was peeled within 1 minute, indicating that it is necessary to use 5 mg / ($cm^2$·min) of acetic acid per 1 $cm^2$ of resist unit area and 1 minute of treatment time.

The present invention has been carried out in order to solve the above problems in the conventional techniques. An object of the present invention is to provide a method of treating a substrate and an apparatus therefor capable of controlling pH alteration on the surface of the substrate caused by acidic substance produced by oxidation decomposition of organic pollutant and thus preventing corrosion of wiring in the removal of organic pollutant by wet ozone gas from a substrate comprising metal having low acid resistance or alkali resistance as a wiring material.

The first process for treating a substrate of the present invention is a process for treating a substrate by removing organic pollutant on the surface of the substrate using mixed gas of wet-ozone containing gas wetted by steam and basic gas, wherein a supply speed of basic gas molecule is at most 100 times as high as the production speed of molecule of acidic substance produced by oxidation reaction of the organic pollutant.

The second process for treating a substrate of the present invention is that a volatile substance is introduced as the basic gas in the above process for treating a substrate.

The third process for treating a substrate of the present invention is that ammonia gas is used as the volatile substance in the second process of the present invention.

The fourth process for treating a substrate of the present invention is that the ammonia gas passed through a saturated aqueous solution of ammonia is used as the ammonia gas in the third process of the present invention.

The fifth process for treating a substrate of the present invention is that a non-volatile substance is used as the basic gas in the first process of the present invention.

The sixth process for treating a substrate of the present invention is that TMAH (tetramethylammonium hydroxide) is used as the non-volatile substance in the fifth process of the present invention.

The seventh process for treating a substrate of the present invention is that the mixing duration from the mixing of the basic gas molecule and the wet ozone-containing gas to the arrival of the gas mixture at the substrate to be treated is controlled to at most 10 seconds in the first process of the present invention.

The eighth process for treating a substrate of the present invention comprises removing organic pollutant on the surface of the substrate using wet ozone-containing gas wetted by a treatment liquid, wherein a solvent capable of preventing ionization of acidic substance produced by the oxidation reaction of the organic pollutant is used as the treatment liquid.

The ninth process for treating a substrate of the present invention is that a solvent having low reactivity to ozone is used as the treatment liquid in the eighth process of the present invention.

The tenth process for treating a substrate of the present invention is that acetic acid or acetone is used as the solvent having low reactivity to ozone in the ninth process of the present invention.

The eleventh process for treating a substrate of the present invention is that the supply speed of molecule of the solvent is controlled to at most 150 times as high as the production speed of molecule of the acidic substance produced by the oxidation reaction of the organic pollutant in the eighth process of the present invention.

The twelfth process for treating a substrate of the present invention is a process for treating a substrate by removing organic pollutant substance on the surface of the substrate using wet ozone-containing gas wetted by a treatment liquid, wherein voltage of wired metal previously formed on the substrate is adjusted.

The first apparatus for treating a substrate of the present invention comprises a substrate heating means for keeping a substrate at temperature higher than room temperature, a wetting means for obtaining wet ozone-containing gas by wetting, with a treatment liquid, ozone-containing gas generated by an ozone generator, a supplying means for supplying the wet ozone-containing gas to substance to be treated on the surface of the substrate, a gas sending tube for connecting the wetting means and the supplying means, a gas heating means for heating each of the wetting means, the supplying means and the gas sending tube to temperature equal to or higher than that of the substrate, and a supplying means for supplying a basic gas-containing gas to the substance to be treated on the surface of the substrate.

The second apparatus for treating a substrate of the present invention further comprises a removing means for removing undesirable impurities generated from the ozone generator in the first apparatus for treating a substrate of the present invention between the ozone generator and the wetting means for wetting the ozone-containing gas.

The third apparatus for treating a substrate of the present invention comprises a substrate heating means for keeping a substrate at temperature higher than room temperature, a wetting means for obtaining wet ozone-containing gas by wetting, with a treatment liquid, ozone-containing gas generated by an ozone generator, a supplying means for supplying the wet ozone-containing gas to substance to be treated on the surface of the substrate, a gas sending tube for connecting the wetting means and the supplying means, a gas heating means for heating each of the wetting means, the supplying means and the gas sending tube to temperature equal to or higher than that of the substrate and a controlling means capable of adjusting the potential of a metal wiring previously formed on the substrate.

BRIEF DESCRIPTION OF DRAWINGS

Fig. 1 is a schematic view showing the constitution of the apparatus for treating a substrate according to Embodiment 1 of the present invention.

Fig. 2 is a result showing the correlation between the flow rate of ammonia gas added and the aluminum film thickness after treatment in Example 1 relating to Embodiment 1 of the present invention.

Fig. 3 is a result showing the correlation between the flow rate of ammonia gas added and the time required for complete removal of a photoresist film in Example 1 relating to Embodiment 1 of the present invention.

Fig. 4 is a result showing the correlation between the flow rate of ammonia gas added and the gas temperature in the inlet periphery of a header 5 in Example 1 relating to Embodiment 1 of the present invention.

Fig. 5 is a result showing the correlation between the mixing duration from the mixing of wet ozone-containing gas and ammonia gas to the arrival of the gas mixture at a substrate and the aluminum film thickness after treatment in Example 2 relating to Embodiment 1 of the present invention.

Fig. 6 is a result showing the correlation between the mixing duration from the mixing of wet ozone-containing gas and ammonia gas to the arrival of the gas mixture at a substrate and the time required for complete removal of a photoresist film in Example 2 relating to Embodiment 1 of the present invention.

Fig. 7 is a result showing the correlation between the liquid temperature of aqueous ammonia and the time required for complete removal of a photoresist film in Example 3 relating to Embodiment 1 of the present invention.

Fig. 8 is a result showing the correlation between the sprayed amount of an aqueous TMAH solution and the aluminum film thickness after treatment in Example 4 relating to Embodiment 1 of the present invention.

Fig. 9 is a result showing the correlation between the sprayed amount of an aqueous TMAH solution and the time required for complete removal of a photoresist film in Example 4 relating to Embodiment 1 of the present invention.

Fig. 10 is a result showing the correlation between the residence time from the mixing of an ozone-containing gas and acetic acid vapor to the supply of the mixture to a substrate and the aluminum film thickness after treatment in Example 6 relating to Embodiment 1 of the present invention.

Fig. 11 is a result showing the correlation between the potential of a wiring metal and the wiring metal film thickness after treatment in Example 10 relating to Embodiment 1 of the present invention.

Fig. 12 is a schematic view showing the reaction mechanism of Examples 1 and 2.

Fig. 13 is a schematic view showing the reaction mechanism of Example 3.

Fig. 14 and Fig. 15 are schematic view showing the constitutions of main units of the apparatus for treating a substrate according to Embodiment 1 of the present invention.

Fig. 16 is a schematic view showing the constitution of main units of the apparatus for treating a substrate in Example 3 relating to Embodiment 1 of the present invention.

Fig. 17 is a schematic view showing the constitution of main units of the apparatus for treating a substrate in Example 4 relating to Embodiment 1 of the present invention.

Fig. 18 is a schematic view showing the constitution of the apparatus for treating a substrate according to Embodiment 2 of the present invention.

Fig. 19 is a schematic view showing the constitution of the apparatus for treating a substrate according to Embodiment 3 of the present invention.

Fig. 20 is a schematic view showing the constitution of the apparatus for treating a substrate according to Embodiment 4 of the present invention.

Fig. 21 is a schematic view showing main units of the constitution of the apparatus for treating a substrate according to Embodiment 4 of the present invention.

Fig. 22 is a schematic view showing the constitution of the apparatus for treating a substrate according to Embodiment 5 of the present invention.

Fig. 23, Fig. 24 and Fig. 25 are illustrations showing the constitution of conventional apparatus for treating a substrate by wet ozone-containing gas.

Fig. 26 is a result showing the correlation between the flow rate of nitrogen dioxide gas added and the aluminum film thickness after treatment, which is a reference example relating to Embodiment 1 of the present invention.

## BEST MODE FOR CARRYING OUT THE INVENTION

### EMBODIMENT 1

Fig. 1 is a view showing the constitution of an apparatus for treating a substrate according to Embodiment 1 of the present invention. A substrate 2 disposed in a treatment chamber 1 is fixed on a plate heater 4 attached to a substrate stand 3. A header 5 to evenly supply wet ozone-containing gas to the surface of the substrate to be treated by controlling the gas flow is installed above the substrate 2 and is provided with a mechanism capable of heating to at least room temperature if necessary. The facilities for generating the ozone-containing gas comprises an ozone gas generator 6, a humidifier 7 for humidifying the ozone gas, a gas sending tube 8b for introducing the humidified ozone gas into the treatment chamber 1, a ribbon heater 9 for preventing condensation of steam in the gas sending tube 8b, a pure water tank 10 for washing the substrate 2 after ozone treatment, a pump 11 for sending washing water, a gas discharge tube 12 for discharging the ozone-containing gas and a gas discharge adjustment valve 13 for adjusting the discharge amount of the ozone-containing gas. A chemical substance to be added for preventing wiring corrosion is generated in an additive gas generator 18 and the gas generator 18 is connected to the treatment chamber 1 through the gas sending tubes 8a and 8c and can be heated by the ribbon heater 9 if necessary. Although not being illustrated, a mass flow controller is used to control the flow rate of an additive gas. The wet ozone-containing gas and the additive gas are previously mixed at the point d mm before the mixed gas supply port which is the lower end of the header 5, and then introduced to the object surface to be treated of the substrate 2 through the gas sending tube 8c having an inner diameter of 6 mm. A temperature measurement apparatus 19 is installed at the supply port of the header 5 to measure the gas temperature.

As the humidifier 7, an example to be employed is an apparatus with a constitution as illustrated in Fig. 14 such that an ozone-containing gas is passed through a treatment liquid 16 stored in a bubbling bottle 17 and a heater 15 is installed to heat the treatment liquid 16 to at least room temperature. As the additive gas generator 18, for example, a pressure tank 20 filled with reactive gas at a high pressure as illustrated in Fig. 15 is employed and the flow rate is controlled by a mass flow controller 21. Incidentally, among the constituent members of the entire apparatus, those to be exposed to the wet ozone gas are made of a material having high ozone resistance, such as quartz glass or a fluororesin. An ozone gas decomposition tower 14 is installed in the rear stage of the gas discharge tube 12 and the remaining ozone gas is completely decomposed and discharged as oxygen gas.

In a substrate treatment method, at first the substrate 2 is heated to a prescribed temperature by the plate heater 4. Further, the treatment liquid 16 of the humidifier 7 (Fig. 14), the gas sending tube 8a, the gas sending tube 8b, the gas sending tube 8c and the header 5 are also previously heated and stabilized at a prescribed temperature. When the temperature of the substrate 2 is stabilized, the ozone-containing gas is passed through the humidifier 7 and wet ozone-containing gas accompanied with humidity is supplied to the object to be treated on the substrate 2. At the same time, additive gas generation from the additive gas generator 18 is started and the flow rate is adjusted by the mass flow controller to supply the gas to the substrate 2. In this case, humidity of the ozone-containing gas in the humidifier 7 is equivalent to the saturated steam at the treatment liquid temperature and the amount of vapor within the ozone-containing gas can be controlled by changing temperature of the treatment liquid. After the object to be treated is decomposed by treatment for a prescribed period, the supply of the wet ozone-containing gas and the supply of the additive gas are stopped, the pump 11 is operated, pure water is supplied from the pure water tank 10, and the surface of the substrate 2 is rinsed. Following that, nitrogen gas is supplied to dry the surface of the substrate 2 sufficiently.

Embodiment 1 will be described in detail with reference to examples.

### EXAMPLE 1

After a positive-type photoresist (TFR-B available from Tokyo Ohka Kogyo Co., Ltd.) was applied to a surface-cleaned substrate (a 0.7 mm-thick glass substrate on which a 200 nm-thick Al film was already formed) by a spin coater, pre-baking was carried out at 120°C for 3 minutes to form a photoresist film of 1,450 nm thick as an object to be treated. Further, using a photomask with hole patterns having a diameter of 10 μm at every 0.1 mm, exposure treatment and development treatment were carried out to form a large number of holes having a diameter of 10 μm and a depth of 1,450 nm at 0.1 mm intervals. In the inner parts of the holes, the A1 film existing under the photoresist film was completely exposed. In Fig. 1, the substrate 2 having a size of 200 mm × 200 mm was set upward on the plate heater 4 in the treatment chamber 1 and heated to 73°C. The gas sending tube 8a, the gas sending tube 8b, the gas sending tube 8c and the header 5 were heated to 90°C and after the respective temperature levels were stabilized, wet ozone-containing gas (ozone concentration: 200 g/$Nm^3$) which had been passed through pure water heated to 90°C and humidified by the humidifier 7 was supplied at a flow rate of 5,000 cc/minute. The humidity of the wet ozone-containing gas was adjusted to be the saturated steam concentration at 90°C. Ammonia gas was used as a basic gas added to prevent wiring corrosion while the gas flow rate was adjusted by a mass flow controller. The ammonia gas and the wet ozone-containing gas were mixed at the point d =100 mm before the supply port of the header 5 and supplied to the surface of the substrate 2.

After substrate treatment with wet ozone-containing gas and ammonia gas for 1 minute, pure water of 55°C was supplied to the substrate 2 at a flow rate of 3,000 cc/minute to remove the decomposed photoresist film. A series of the steps of 1-minute substrate treatment and the rinsing with pure water was repeated until the photoresist film on the substrate 2 was completely removed.

Ammonia gas flow rate was changed from 0 to 7,000 cc/minute and the Al film thickness after the complete removal of the photoresist film by wet ozone-containing gas and ammonia gas was measured by a stylus type film thickness profilometer.

The results of Example 1 are shown in Fig. 2. Together with the Al film thickness measured values, the pH on the surface of the substrate 2 measured before rinsing with pure water is shown. Fig. 2 shows that the pH on the substrate was increased (the acidity was decreased) as the flow rate of ammonia gas was increased. In the case where no ammonia gas was introduced, the pH on the substrate 2 became about pH 2 and the Al film was completely dissolved. In the case where the flow rate of ammonia gas was 40 to 1,500 cc/minute, the pH was within a range (pH = 4 to 9) in which Al could be stabilized in the form of an oxide film, and therefore corrosion of the Al film was completely prevented. However, when the flow rate of ammonia gas was further increased, the Al film thickness was gradually decreased at a flow rate of at least 1,500 cc/minute, and the surface of the substrate 2 became alkaline with pH of at least 9 and the Al film was partially dissolved at a flow rate of 2,000 cc/minute.

Then, in Fig. 3, the time required for complete removal the photoresist film is shown as a relative value based on the time of using no ammonia gas as 1. It is found that the removal speed of the photoresist film was increased when the flow rate of ammonia gas was in a range of 40 to 1,500 cc/minute in which the Al film dissolution was prevented. Further, when the flow rate of ammonia gas was 2,000 cc/minute, it took as long as twice the time for complete removal.

The measurement results by the temperature measurement apparatus 19 installed in the header supply port are shown in Fig. 4. When the flow rate of ammonia gas was 0, the apparatus indicated at 90°C, which was the set value of the gas temperature. As ammonia gas was introduced, the gas temperature was gradually increased and reached 260°C when the flow rate of ammonia gas was 6,000 cc/minute. The cause is supposed to be heat generation due to the interaction of ammonia and ozone. Since ammonia gas was added at 6,000 cc/minute while ozone gas was added at 5,000 cc/minute, the ammonia concentration becomes 55 %. When the flow rate of ammonia gas was 6,000 cc/min, the ammonia concentration is within the combustible range (13.5 to 79 %) relative to oxygen. Further, the maximum reaction heat is as high as 1,350 cal/g. From these facts, it is thought that the temperature increase from 90°C to 260°C is appropriate.

In this Example, an ozone-resistant material is desirable for the treatment chamber 1 and the tubes. A fluororesin generally has chemical resistance and ozone resistance, but the highest temperature for continuous use is relatively low: 260°C in the case of PTFE; 260°C in the case of PFA; and 200°C in the case of FEP. Since PTFE was used in this Example, it is necessary to adjust the gas temperature to at most 260°C. Consequently, the flow rate of the ammonia gas to be added is desirably at most 6,000 cc/minute.

The amount of ammonia gas supply is investigated. The speed of acidic substance production by gradual decomposition of a photoresist film by ozone-containing gas can be described as the following equation. However, since the detailed composition of the acidic substance is not known, the equation is expressed on the basis of conversion of the substances into acetic acid detected as a typical substance.

$$\text{(the production speed of acidic substance)} = \text{(photoresist film decreasing speed)} \times \text{(the carbon ratio in the photoresist average molecule/the carbon ratio in acetic acid molecule)} + \text{(carbon molecular weight)} \quad (1)$$

The photoresist film having an initial film thickness of 1,450 nm (a total photoresist weight on the substrate of 200 mm × 200 mm is 0.0324 g) was completely removed by carrying out the 1-minute treatment twice. The carbon ratio in the acetic acid molecule is 0.4 and the carbon ratio in the average molecular weight of the photoresist becomes 0.8 assuming the photoresist to be a novolak resin. Consequently,

$$\text{(the production speed of acetic acid)} = (0.0324\text{g}+2\text{minute}) \times (0.8/0.4) + 12 = 2.7 \times 10^{-3} \text{ mol/minute} \quad (2)$$

Since the amount of ammonia gas needed to neutralize the acidic substance is equal to the amount of the acidic substance, the necessary amount of ammonia gas can be described as the following equation using the degree of ionization of ammonia and the degree of ionization of acetic acid in an aqueous solution.

(the necessary amount of ammonia gas) = (the production speed of acetic acid) $\times$ (the degree of ionization of acetic acid + the degree of ionization of ammonia) (3)

According to Kagaku Binran (Chemical Handbook) Basic (3rd edition) II, p. 343, the degree of ionization of ammonia pKb = 4.8 and the degree of ionization of acetic acid pKa = 4.8, which means equal. Accordingly,

$$\text{(the necessary amount of ammonia gas)} = 2.7 \times 10^{-3} \text{ mol/minute} \times (1 + 1) \times 22{,}400 \text{ cc/mol} = 60.5 \text{ cc/minute.}$$

Consequently, the theoretical value of the necessary amount of ammonia gas for neutralization is found to be about 60 cc/minute.

According to the results shown in Fig. 2, the Al film dissolution was prevented in an ammonia gas flow rate range of as wide as 40 to 2,000 cc/minute. It is supposed that the reason for the successful prevention of dissolution in spite of adding ammonia in an amount of about thirty-three times the theoretical necessary amount for neutralization of 60 cc/minute is that part of the introduced ammonia was oxidized and consumed by ozone owing to the interaction between ozone and ammonia. When the flow rate of ammonia gas is in the range of 40 to 1,500 cc/minute, the Al film dissolution was completely prevented since the pH on the substrate was controlled to pH 4 to 9 owing to the interaction between ozone, ammonia and acidic substance. Even when the flow rate of ammonia gas was at least 1,500 cc/minute, prevention of the Al film dissolution was successful compared to the case where the flow rate of ammonia gas was 0 cc/minute, though the pH became at least pH 9, the Al film being partly dissolved. On the other hand, as shown in Fig. 4, ammonia and ozone were interacted with each other to generate heat, resulting in increase of gas temperature. Since PTFE was used in this Example, the gas temperature was required to be at most 260°C, i.e., temperature for continuous use of PTFE. Consequently, the flow rate of ammonia gas to be added is preferably 6,000 cc/min at highest.

In this Example, ammonia was added for the purpose of neutralizing the acidic substance produced along with the oxidation of the resist film. Since the theoretical value of the ammonia gas flow rate necessary to neutralize the produced acidic substance is 60 cc/minute, it is required to adjust the ammonia gas flow rate to 6,000 cc/minute at highest in order to use PTFE safely as a tube material at temperature of at most 260°C. Since the production speed of the acidic substance molecule produced along with the resist decomposition is equal to the supply speed of ammonia molecule contained in the ammonia gas supplied at a flow rate of 60 cc/min, the supply speed of the ammonia molecule at the above maximum ammonia gas flow rate of 6,000 cc/minute is 100 times as high as the production speed of the acidic substance molecule mentioned above.

In a process for treating a substrate, it is preferable to control the decreasing amount of an Al film to at most 100 nm from a practical point of view. This is because there arise defects in properties of metal as wiring when the Al film is decreased by more than 100 nm. Accordingly, from Fig. 2, it is preferable to adjust the flow rate of ammonia gas to be at most 2,000 cc/minute and adjust the supply speed of ammonia gas to be at most thirty-three times as high as the production speed of the acidic substance.

Further, it is necessary to prevent the dissolution of the wiring as much as possible in the process where high properties are required for wiring metal. According to Fig. 2, it is possible to control the pH on the substrate to at most pH 9 and the dissolution of the Al film is completely prevented in the case where the flow rate of ammonia gas was at most 1,500 cc/minute. For the process where such high properties are required, it is preferable to adjust the flow rate of ammonia gas to be at most 1,500 cc/minute and adjust the supply speed of ammonia gas to be at most twenty-five times as high as the production speed of the acidic substance.

In this Example, similar tendency was seen as to the change of metal film thickness in relation to the introduced amount of ammonia, when a substrate comprising an Al-containing mixture obtained by mixing Cu, Nd, Si, Ti, W, Ta, Mo or the like to Al was used as wiring instead of the film made of Al alone.

According to this Example, by keeping the temperature of the substrate 2 to at least room temperature and by adjusting the temperature of the wet ozone gas supplied to the photoresist film on the substrate 2 to at least the temperature of the substrate 2, a proper water film was formed on the substrate and the photoresist film was removed.

Further, it was also proved that the Al film dissolution attributed to the acidic substance produced by oxidation decomposition of the photoresist due to ozone could be prevented by controlling the pH on the surface of the substrate 2 with adjusting the flow rate of ammonia gas.

In this Example, ammonia gas was employed as the basic gas, but pyridine, ethylamine, dimethylamine, tetramethylamine, tributylamine, dibutylamine, triethylamine, aniline and the like are also effective. According to Kagaku Binran (Chemical Handbook) Basic (3rd edition) II, p. 343, tetramethylamine has ionization coefficient of 3.2 and ionization degree of at least 10 times as high as that of ammonia. Therefore, the amount of basic gas necessary to neutralize the acidic substance derived from the photoresist film is smaller in case of tetramethylamine than in case of ammonia. Having volatile property, amines such as tetramethylamine mentioned above can be supplied by the method of Example 1. In this manner, a basic gas other than ammonia gas can neutralize the acidic substance produced by oxidation of the resist film and prevent the Al film dissolution. Among the basic gases, a volatile basic gas such as tetramethylamine or ammonia can be supplied in a state of gas as an additive gas generation method. Therefore, adjustment of the amount becomes easier, making it possible to prevent an Al film from dissolving further efficiently.

## EXAMPLE 2

Example 2 is one in which the flow rate of ammonia gas in Example 1 was fixed to 60 cc/minute and the flow rate of ozone gas in Example 1 was adjusted to 5,000 cc/minute. In this Example, the distance d (hereinafter sometimes referred to as "mixing distance" for short) from the point of mixing ammonia gas with wet ozone-containing gas to the point of supplying the gas mixture through the header 5 was changed, whereas the distance was set to 100 mm in Example 1. A series of the steps of 1-minute substrate treatment and the rinsing with pure water was repeated until the photoresist film on the substrate 2 was completely removed in the same manner as in Example 1.

The mixing distance d of ammonia gas and wet ozone-containing gas was changed in a range of 10 mm to 20 m and the Al film thickness after the complete removal of the photoresist by wet ozone-containing gas and ammonia gas was measured using a stylus type film thickness profilometer.

The results of Example 2 are shown in Fig. 5. In the figure, the time from the mixing of wet ozone-containing gas and ammonia gas to the supply is defined as mixing time $t_M$. The mixing time is calculated from the mixing distance and shown in the x-axis. The pH on the surface of the substrate 2 measured before rinsing with pure water is shown together with the Al film thickness measured value. When the mixing time was shorter than that of Example 1, ($t_M$ = 50 msec), there was no change in the Al film thickness and the pH on the substrate surface. However, when the mixing time was at least 1 second, the pH on the substrate became at most pH 4 and the Al film was partly dissolved. On the other hand, Fig. 6 shows time dependency (hereinafter sometimes referred to as "complete removal time") which means the time required for complete removal of the photoresist film completely (shown as relative values based on the complete removal time of the case without ammonia gas introduction as 1 in the same manner as in Fig. 3). When the mixing time $t_M$ was 5 msec, the complete removal time was about 0.8 which was similar to that in the case where the mixing time $t_M$ was 50 msec. When the mixing time $t_M$ was at least 2 sec, the complete removal time became twice longer than that in the case where no ammonia gas was introduced. Further, it took four times longer when the mixing time was 10 sec.

However, when the mixing time is long, interaction time of ozone and ammonia is long, and therefore, heat is generated due to reaction, resulting in increase of the gas temperature. As the mixing time was prolonged, the gas temperature was increased and reached 260°C when the mixing time was 10 sec. In this Example, since PTFE was used for the reaction material, it is necessary to set the gas temperature to at most the temperature for continuous use (260°C). Therefore, the mixing time is desirably 10 sec at longest.

The results of Example 2 can be explained as follows. The wet ozone-containing gas caused chemical interaction between ammonia gas and it is possible that ozone and ammonia are consumed owing to the interaction when the mixing distance is too long. More specifically, when the flow rate of ammonia gas is 60 cc/minute and the mixing time $t_M$ is at most 1 sec (the mixing distance is at most 2 m), the interaction between ozone and ammonia is small and affects neither the Al film corrosion prevention effect nor the photoresist removal speed. However, when the mixing time $t_M$ is at least 1 sec, the interaction duration of ammonia gas and ozone gas becomes long and ammonium nitrate is produced. That is, ammonia and ozone are consumed uselessly. Owing to the consumption of ammonia gas, the acidic substance produced on the substrate surface attributed to the photoresist decomposition cannot be neutralized and the Al film corrosion proceeds. On the other hand, it can be accounted that when ozone is consumed, the ozone concentration is decreased to cause decrease in the speed of the oxidation decomposition of the photoresist film.

In this Example, similar tendency was seen as to the change of metal film thickness in relation to the introduced amount of ammonia, when a substrate comprising an Al-containing mixture obtained by mixing Cu, Nd, Si, Ti, W, Ta, Mo or the like to Al was used as wiring instead of the film made of Al alone.

According to the above Examples 1 and 2, the reaction mechanism in the process for treating a substrate is explained with reference to the schematic illustrations shown in Fig. 12. In a conventional case, as shown in Fig. 12(a), a photoresist film 34 is oxidized to produce acidic substance by wet ozone-containing gas comprising water molecules 31 and ozone molecules 32 supplied from the upper side of the substrate 2. The acidic substance is ionized in a thin water film 33 formed on the photoresist film to produce hydrogen ions 36. The photoresist film 34 has holes orderly formed at every 0.1 mm and wiring metal 35 previously formed under the photoresist film 34 is exposed. The hydrogen ion 36 produced from the above acidic substance affects wiring metal 35 through the holes formed in the photoresist film 34 to promote corrosion.

On the other hand, Examples 1 and 2 can be explained with reference to Fig. 12(b). Wet ozone-containing gas comprising water molecules 31 and ozone molecules 32 together with ammonia molecules 37 are supplied on the substrate 2 with interaction 39 proceeding. Although acidic substance is produced in a thin water film 33 by the oxidation reaction of the photoresist film 34 with ozone gas, they are successively neutralized by ammonia gas supplied simultaneously and therefore the amount of hydrogen ions is not increased. Therefore, it is possible to prevent the corrosion of the orderly exposed wiring metal film 35. However, as found in Example 2, when the interaction (the mixing time) 39 of the gas mixture until the gas mixture is supplied to the substrate 2 is long, there is a possibility of wasteful consumption before reaching the substrate.

EXAMPLE 3

Example 3 is one in which the substrate temperature in Example 1 was adjusted to 75°C. In Example 1, the pressure tank 20 (Fig. 15) filled with a reactive gas at a high pressure was employed as the additive gas generator 18 (Fig. 1), whereas a humidifier is installed in the rear of a pressure tank 20 in this Example as shown in Fig. 16. As the humidifier, the one employed has a constitution such that ammonia gas is passed through a saturated aqueous solution of ammonia 22 stored in a bubbling tank 23 and is provided with a heater 15 for heating the saturated aqueous solution of ammonia 22 to at least room temperature. In Example 3, the temperature of the saturated aqueous solution of ammonia 22 was changed and a series of the steps of 1-minute substrate treatment and the rinsing with pure water was repeated until the photoresist film on the substrate 2 was completely removed in the same manner as in Example 1.

The temperature of the aqueous ammonia solution was changed in a range of 1 to 90°C, and the time required for complete removal the photoresist by wet ozone-containing gas and ammonia gas was measured. The mixing distance d was set to be d = 100 mm (mixing time $t_M$ = 50 msec) and the flow rate of ammonia gas was set to be 60 cc/min. Incidentally, the gas sending tube 8a (Fig. 1) to introduce ammonia gas was adjusted to be at 95°C in order to prevent dew formation inside the tube.

The results of Example 3 are shown in Fig. 7. Fig. 7 shows time dependency (hereinafter sometimes referred to as "complete removal time") which means the time required for complete removal of the photoresist film completely. The results are shown in relative values based on the time in case of the aqueous ammonia temperature of 1°C as 1. With the increase of the humidity accompanying ammonia gas, the complete removal time of the photoresist film was shortened by 30 to 40%.

As shown in this Example, effect of adding ammonia was sufficient even if the mixing time was 10 sec, owing to the use of wet ammonia gas produced by passing ammonia gas through a saturated aqueous solution of ammonia.

The effect of passing ammonia gas through the saturated aqueous solution of ammonia can be explained as follows. It is supposed that part of the ammonia gas passed through saturated ammonia is present in the form of ammonium hydroxide ($NH_4OH$) and then mixed with wet ozone-containing gas. According to Environmental Science & Technology Vol. 12 Number 1 (January 1978) p. 79-84, reactivity of ammonia and reactivity of ammonium ion with ozone are described as follows:

$$NH_4^+ + O_3 \rightarrow \text{no reaction}$$

$$NH_3 + O_3 \rightarrow NO_3^- \text{ (rate constant 20.4 L/(mol*sec))}$$

Since ammonium hydroxide comprises ammonium ion, ammonium hydroxide is supposed to have lower reactivity with ozone than ammonia.

In Example 3, the effect of adding ammonia gas was observed even in the case of the mixing time of as long as 10 sec. This is because ammonia was converted to ammonium hydroxide ($NH_4OH$) 38 by passing ammonia through saturated ammonia and the interaction after mixing wet ozone-containing gas and wet ammonia gas was prevented as shown in the schematic illustration of Fig. 13.

EXAMPLE 4

In Example 4, experiment was carried out as to the case of using an aqueous solution containing TMAH (tetramethylammonium hydroxide) (hereinafter sometimes referred to as "TMAH aqueous solution" for short) as the basic substance which was added in Example 1 to prevent wiring corrosion. Since TMAH (tetramethylammonium hydroxide) in the TMAH aqueous solution is a non-volatile substance, a humidifier equipped with an ultrasonic oscillator is employed. As shown in Fig. 17, the humidifier employed has a constitution such that nitrogen gas is passed through the TMAH aqueous solution 25 stored in a bubbling tank 26 and an ultrasonic oscillator 24 is installed thereto in order to generate finely atomized vapor from the TMAH aqueous solution. The flow rate of nitrogen gas supplied from a nitrogen gas bomb 27 is controlled by a mass flow controller 21. With changing the supply amount of the TMAH aqueous solution, a series of the steps of 1-minute substrate treatment and the rinsing with pure water was repeated until the photoresist film on the substrate 2 (Fig. 1) was completely removed in the same manner as in Example 1. Further, nitrogen gas containing TMAH aqueous solution was mixed with wet ozone-containing gas at the point d = 100 mm before the supply port of the header 5 and the mixed gas was supplied to the surface of the substrate 2.

The TMAH concentration in the TMAH aqueous solution was adjusted to 0.28 mol/L and atomizing power of the ultrasonic oscillator 24 was changed. Then, the Al film thickness after removing the photoresist completely by wet ozone-containing gas and TMAH-aqueous-solution containing nitrogen gas was measured by a stylus type film thickness profilometer.

The results of Example 4 are shown in Fig. 8. The pH on the surface of the substrate 2 measured before rinsing with pure water is shown together with the Al film thickness measured values. Fig. 8 show that the pH on the substrate was increased (the acidity was decreased) with the increase of the atomized amount of the TMAH aqueous solution. When the atomized amount of the TMAH aqueous solution was 4 to 40 (9.5 g/minute to 95 g/minute), the pH was within a range (pH = 4 to 9) in which Al could be stabilized in the form of an oxide film, and therefore it was possible to prevent the Al film from corroding completely. When TMAH aqueous solution was not introduced, the pH on the substrate 2 was about pH 2 and the Al film was completely dissolved. On the other hand, when the amount of the TMAH aqueous solution was further increased such that atomized amount was at least 40, the surface of the substrate 2 became alkaline of at least pH 9 and the Al film was completely dissolved. Next, the time required for complete removal of the photoresist film is shown in Fig. 9 as relative values based on the time required when TMAH aqueous solution was not introduced as 1. It is found that the removal speed of the photoresist film is improved when the atomized amount was in the range of 4 to 40 in which the Al film dissolution was prevented. It was found that it took at least four times longer for complete removal when the atomized amount was 400. Herein, the atomized amount of the TMAH aqueous solution and the amount of actual introduction have such a relationship as shown in Table 1.

TABLE 1

| Sprayed amount of aqueous TMAH solution | Actual amount of introduction (g/minute) |
|---|---|
| 4 | 9.5 |
| 50 | 119 |
| 200 | 475 |

With the introduction of the TMAH aqueous solution, the gas temperature was gradually increased and reached 260°C when the atomized amount was 400 (950 g/min). The cause is supposed to be heat generation due to the interaction between the TMAH aqueous solution and ozone. In this Example, an ozone-resistant material is desirable for the treatment chamber 1 or the tubes. A fluororesin generally has chemical resistance and ozone resistance, but the highest temperature for continuous use is relatively low: 260°C in the case of PTFE; 260°C in the case of PFA; and 200°C in the case of FEP. Since PTFE was used in this Example, it is necessary to adjust the gas temperature to at most 260°C. Therefore, the flow rate of the ammonia gas to be added is desirably at most 400 (950 g/min) in the atomized amount.

The supply amount of the TMAH aqueous solution is discussed below. When the atomized amount of ultrasonic oscillator used for atomizing the TMAH aqueous solution is 4, the aqueous solution of about 9.5 g/minute is atomized.

$$(\text{TMAH introduction amount}) = 9.5\text{g/minute} \times 0.28\text{mol/L} \times 1{,}000\text{g/L} =$$

$$2.67 \times 10^{-3}\ \text{mol/minute}$$

Therefore, it was possible to prevent the dissolution of the Al film by introducing an alkaline substance equivalent to the production speed of the acidic substance derived from the oxidation decomposition of the photoresist as described in Example 1.

According to the results shown in Fig. 8, the Al film dissolution was prevented in an atomized amount of as wide as 4 to 40 (9.5 g/min to 95 g/min). It is supposed that the reason for the successful prevention of dissolution in spite of adding TMAH in an amount of about ten times the theoretical necessary amount for neutralization is that part of the introduced TMAH was oxidized and consumed by ozone owing to the interaction between ozone and TMAH. In an atomized amount range of 4 to 40, dissolution of the Al film was completely prevented since the pH on the substrate was controlled to pH 4 to 9 owing to the interaction between ozone, TMAH and acidic substance. Even when the atomized amount was at least 40 (95 g/min), prevention of the Al film dissolution was successful compared to the case where TMAH was not atomized, though the pH became at least pH 9, the Al film being partly dissolved. On the other hand, TMAH and ozone were interacted with each other to generate heat, resulting in increase of gas temperature. Since PTFE was used in this Example, the gas temperature was required to be at most 260°C, i.e., temperature for continuous use of FTFE. Consequently, the atomized amount of TMAH is preferably 950 g/minute at highest.

In this Example, TMAH was added for the purpose of neutralizing the acidic substance produced by the resist film oxidation. Since the theoretical value of the atomized amount of TMAH necessary for neutralizing the produced acidic substance is 9.5 g/minute, it is required to control the atomized amount of the TMAH to at most 950 g/minute in order to use PTFE safely as a tube material at a temperature of at most 260°C. The production speed of the acidic substance produced along with the resist decomposition is equal to the supply speed of TMAH molecule in case of atomized amount of 9.5 g/minute. Therefore, the supply speed of TMAH molecule in case of the maximum atomized amount of TMAH of 950 g/minute is 100 times as much as the production speed of the above acidic substance.

In this Example, the TMAH aqueous solution was used as the basic substance to prevent wiring corrosion. However, hydroxide such as sodium hydroxide or potassium hydroxide, aqueous ammonia and the like are also effective. Generally, since the ionization coefficient of hydroxide is extremely high, the spraying amount of the aqueous basic solution necessary to neutralize the acidic substance derived from a photoresist film can be smaller in case of using an aqueous hydroxide solution than in case of using the TMAH aqueous solution. Since hydroxide mentioned above is not volatile, hydroxide is supplied to the substrate to be treated by spraying the same according to the method described in this Example.

EXAMPLE 5

In Example 5, experiment was carried out as to the case of using an aqueous ammonia as the alkaline substance which was used in Example 1 to prevent wiring corrosion.

The ammonia concentration in the aqueous ammonia was adjusted to $6.7 \times 10^{-1}$ mol/L and the atomizing power of the ultrasonic oscillator 24 was changed, and then, A1 film thickness after complete removal of the photoresist by wet ozone-containing gas and aqueous ammonia-containing nitrogen gas was measured using a stylus type film thickness profilometer.

Similarly to Example 4, with the increase of the atomized amount of the aqueous ammonia, the pH on the substrate was increased (the acidity was decreased) and when the atomized amount of the aqueous ammonia was 4 to 6, the pH was in a range (pH = 4 to 9) in which Al could be stable in the form of an oxide film, and the Al film corrosion was completely prevented.

EXAMPLE 6

In this Example, experiment was carried out as to the case of accompanying acetic acid vapor to an ozone-containing gas by putting acetic acid with 99.7 % purity in the humidifier 7 (Fig. 1) for ozone gas of Example 1. Further, the residence time from the humidifier 7 to the gas mixture supply port of the header 5 in Fig. 1 was changed.

After a positive-type photoresist (TFR-B manufactured by Tokyo Ohka Kogyo Co., Ltd.) was applied to a surface-cleaned substrate 2 (a 0.7 mm-thick glass substrate in which a 200 nm-thick Al film was already formed) by a spin coater, post-baking was carried out at 120°C for 3 minutes to form a photoresist film of 1,450 nm thick as an object to be treated. Further, using a photomask with hole patterns having a diameter of 10 μm at every 0.1 mm, exposure treatment and development treatment were carried out to form a large number of holes having a diameter of 10 μm and a depth of 1,450 nm at 0.1 mm intervals. In the inner parts of the holes, the Al film existing under the photoresist film was completely exposed. In Fig. 1, the substrate 2 having a size of 200 mm × 200 mm was placed on the plate heater in the treatment chamber 1 with the photoresist film upward and heated to 73°C. The gas sending tube 8a, the gas sending tube 8b, the gas sending tube 8c and the header were heated to 90°C and after the respective temperature levels were stabilized, gas containing ozone and acetic acid (ozone concentration: 200 g/$Nm^3$) which had been passed through acetic acid heated to 90°C and humidified by the humidifier 7 was supplied at a flow rate of 3,000 cc/minute. The vapor pressure of acetic acid in the gas containing wet ozone and acetic acid (hereinafter sometimes referred to as acetic acid- and ozone-containing gas) was adjusted to the saturated vapor pressure at 90°C.

After substrate treatment with the acetic acid- and ozone-containing gas for 1 minute, pure water of 55°C was supplied to the substrate 2 at a flow rate of 3,000 cc/minute to remove the decomposed photoresist film. A series of the steps of 1-minute substrate treatment and the rinsing with pure water was repeated until the photoresist film on the substrate 2 was completely removed.

The results of Example 6 are shown in Fig. 10. In the range of residence time of 0.01 to 1.0 second, the pH on the surface of the substrate after the photoresist removal was approximately neutral (pH = 5 to 6) and no change was observed in the A1 film thickness. The time required for complete removal of the photoresist film is shown in Table 2. Table 2 shows the correlation between the mixing duration from the mixing of ozone-containing gas and acetic acid vapor to the arrival of the gas mixture at a substrate and the time required for complete removal of the photoresist film. When the time for the complete removal by the wet ozone-containing gas at 90°C in Example 1 was set to be 1, the time for the complete removal by the acetic acid- and ozone-containing gas was shortened to be 0.5 to 0.6.

TABLE 2

| | Treatment method | Complete Removal Time (Arbitrary) |
|---|---|---|
| Example 1 | Introducing no acetic acid | 1 |
| Example 6 | Residence Time 0.1 second | 0.5 |
| | Residence Time 1 second | 0.6 |

According to "Theory and Practice of Ozone Use", p. 279, published by Realize Co., acetic acid is stable to ozone since acetic acid is the final product of ozonization reaction. Different from Example 2, ozone and the acetic acid vapor showed no interaction even if the time from mixing ozone with acetic acid to the arrival of the mixture at the gas supply port of the header was about 1 second. It is thought that results as shown in Fig. 10 were obtained for this reason.

The mechanism of preventing Al film dissolution in this Example will be explained. According to Kagaku Binran (Chemical Handbook) Basic (3rd edition) II, p. 343, the dissociation constants of acidic substance and basic substance in acetic acid solvent are: methanol 9.7; ethanol 10.2; acetonitrile 22.3; N,N-dimethylformamide (DMF) 11.1; dimethyl sulfoxide (DMSO) 12.6; pyridine about 12; and water 4.8, as shown in Tables 3 and 4.

TABLE 3

| solvent | methanol | ethanol | acetonitrile (AN) | N, N-dimethyl formamide (DMF) | dimethyl sulfoxide (DMSO) | pyridine | acetic acid | Reference Value water |
|---|---|---|---|---|---|---|---|---|
| dielectric constant ε r (25°C) | 32.63 | 24.3 | 36.2 | 36.7 | 46.7 | 12.3 | 6.2 | 78.54 |
| self dissociation index $pK_{auto}$ (25°C) | 16.7 | 19.1 | >33.3 | | about 17.3 | | 14.45 | 14.00 |
| acid dissociation index $pK_a$ | activity | activity | concen-tration | concen-tration | concen-tration | concen-tration | concen-tration | activity |
| $HClO_4$ | | | | strong | | 3.3 | 4.9 | |
| HCl | 1.2 | 2.1 | 8.9 | 3.4 | | 5.7 | 8.6 | (-3.7) |
| HBr | (+0.8) | 1.7 | 5.5 | 1.8 | | 4.4 | 6.1~6.7 | (-4.1) |
| HI | | | | | | 3.4 | | |
| $HNO_3$ | 3.2 | 4.0 | 8.9 | | | 4.1 | 9.4 | (-1.8) |
| $H_2SO_4$ ($pK_1$) | | | 7.2 | 4.3 | | | 7.2 | |
| ($pK_2$) | | | 25.9 | | 14.5 | | | 1.9 |
| acetic acid | 9.7 | 10.2 | 22.3 | 11.1 | 12.6 | ~12 | | 4.8 |
| chloroacetic acid | 7.8 | 8.5 | | 9.0 | | | | 2.9 |
| dichloroacetic acid | 6.3 | 6.9 | | 7.2 | | | | |
| trichloroacetic acid | | | | | | | 11.5 | |
| benzoic acid | 9.4 | 10.2 | 20.7 | 11.7 | 11.1 | ~11 | | 4.2 |
| o-nitrobenzoic acid | 7.6 | 8.3 | | 10.1 | | | | 2.2 |
| m-nitrobenzoic acid | 8.4 | 8.9 | | | | | | 3.5 |
| p-nitrobenzoic acid | | | | 10.6 | | | | 3.4 |
| 3, 5-dinitrobenzoic acid | | | 16.9 | 8.5 | | | | 2.8 |
| salicylic acid | 7.6 | | 16.7 | 8.9 | 6.8 | | | 3.0 |

TABLE 4

| solvent | methanol | ethanol | acetonitrile (AN) | N, N-dimethyl formamide (DMF) | dimethyl sulfoxide (DMSO) | pyridine | acetic acid | Reference Value |
|---|---|---|---|---|---|---|---|---|
| | | | | | | | | water |
| phenol | 14.0 | | 27.2 | >15 | 16.4 | | | 9.9 |
| o-nitrophenol | | | 22.2 | 12.2 | 11.0 | | | 7.2 |
| m-nitrophenol | | | | 13.9 | | 12.5 | | 8.4 |
| p-nitrophenol | | | 20.7 | 12.2 | 11.0 | | | 7.1 |
| 2, 4-dinitrophenol | 7.9 | 8.3 | | 6.3 | | 4.4 | | 4.1 |
| 2, 5-dinitrophenol | | | | | | 5.8 | | 5.2 |
| 2, 6-dinitrophenol | 7.7 | | 16.5 | 6.2 | 4.9 | 3.7 | | 3.7 |
| 3, 5-dinitrophenol | | | 20.5 | | 7.4 | | | |
| picric acid | 3.8 | | 11.0 | 2.2 | ~1.0 | 3.0 | | 0.3 |
| 5, 5-diethylbarbituric acid | | | 23.4 | | 13.0 | | | 8.0 |
| p-toluenesulfonic acid | | | | | 3.0 | | 8.5 | |
| ammonia | 10.8 | 10.4 | 16.5 | | 10.5 | | 8.1 | 9.2 |
| ethylamine | | | 18.8 | | 11.0 | | | 10.6 |
| diethylamine | | | | | 10.5 | | 8.9 | 10.9 |
| triethylamine | | | 18.5 | | 9.0 | 3.8 | 9.5 | 10.8 |
| butylamine | 11.8 | | | | 11.1 | | 8.6 | 10.6 |
| dibutylamine | | | 18.3 | | 10.0 | 5.5 | | 11.3 |
| tributylanine | | | 18.1 | | 8.4 | | 9.3 | 9.9 |
| tetramethylguanidine | | | | | 13.2 | 9.6 | | (13.6) |
| aniline | 6.0 | 5.7 | 10.6 | | | | | 4.6 |
| pyridine | | 4.7 | 12.3 | | 3.4 | - | 8.5 | 5.2 |
| sodium acetate | | | | | | | 7.9 | |
| bromocresol green | 9.8 | 10.6 | 18.5 | 9.5 | 7.3 | 5.5 | | 4.9 |
| bromocresol purple | 11.3 | 12.1 | | | | 7.5 | | 6.4 |
| bromophenol blue | 8.9 | 9.5~9.6 | | | | 5.3 | | 4.1 |
| bromothymol blue | 12.4 | 13.2 | 22.3 | | 11.3 | | | 7.3 |
| phenol red | 12.8 | 13.6 | 25.0 | | 13.7 | | | 8.0 |
| thymol blue | 4.7/14.0 | 5.4/15.2 | ~27 | 4.9 | ~15 | | | 1.6/9.2 |

For example, the dissociation constant pKa of acidic substance is a logarithm of the dissociation ratio Ka of the acidic substance HA to hydrogen ion $H^+$ and the anion $A^-$.

$$Ka = (\text{hydrogen ion } H^+ \text{ concentration}) \times (\text{the anion } A^- \text{ concentration}) + (\text{acidic substance concentration HA})$$

In this case, as described in Example 1, the substances produced by the oxidation of the photoresist film are mainly acetic acid. Therefore, as to the degree of ionization of the acidic substance produced by oxidation decomposition of the photoresist, it is possible to refer to the dissociation constant of acetic acid to acetic acid itself, which is 14.45 shown in Table 3.

$$Ka = (\text{hydrogen ion } H^+ \text{ concentration}) \times (\text{the anion } A^- \text{ concentration}) + (\text{acidic substance concentration HA}) = 10^{-14.45}.$$

When acetic acid is dissociated to hydrogen ion and an anion, the respective ion concentrations are equal. Also, the acetic acid concentration is about 6.3 mol/L.

$$\text{hydrogen ion } H^+ \text{ concentration} = 1.5 \times 10^{-5} \text{ mol/L}$$

$$pH = -\log (H^+) = 4.9$$

Therefore, even if acidic substance such as acetic acid was produced by oxidation decomposition of the photoresist, pH is theoretically decreased only to about pH = 5.

Then, the required amount of acetic acid will be described. The amount of acetic acid vapor to be introduced to the treatment tank is about 6.4 mg/minute when the temperature of the acetic acid solution is 90°C. On the assumption that all acetic acid vapor introduced turns into dew on the substrate, an acetic acid liquid film having a thickness of 0.064 mg/ ($cm^2$·min) is to be formed per unit surface area of the photoresist film. On the other hand, the conventional method shown in Fig. 25 describes that a 50 μm-thick liquid film is formed on the substrate to peel 1 μm-thick resist within 1 minute, which means 5 mg/ ($cm^2$·min) of acetic acid is required per 1 $cm^2$ unit surface area of the resist and 1-minute treatment. In other words, in this Example, resist was actually removed with acetic acid in an amount only about 1.3 % to the amount required in a conventional technique.

As an index for the load on environment, comparison is made as to the TOC emission amounts from the entire process including the carbon amount contained in the introduced acetic acid and the carbon amount in the photoresist film itself. The TOC amount per unit surface area of the substrate generated when the photoresist film is completely removed within two minutes is as follows:

$$(\text{TOC production speed attributed to photoresist decomposition}) = (\text{decrease rate of photoresist film}) \times (\text{carbon ratio in the average molecule of photoresist}) = (0.0081 \text{ g} + 2 \text{ min}) \times 0.8 + 100 \text{ cm}^2 = 0.032 \text{ mg/(cm}^2\cdot\text{min)} \quad (1)$$

$$(\text{TOC amount attributed to acetic acid introduced in this Example}) = (\text{acetic acid introduction amount}) \times (\text{carbon ratio in acetic acid molecule}) = 6.4 \text{ mg/min} \times 0.4 - 100 \text{ cm}^2 = 0.026 \text{ mg/(cm}^2\cdot\text{min)} \quad (2)$$

(TOC amount attributed to acetic acid introduced in the conventional

$$\text{example (Fig. 25)}) = 5\ mg/(cm^2 \cdot min) \quad (3).$$

In an actual process for treating a substrate, it is necessary to decompose the organic matter in waste liquid from apparatus. When acetic acid in an amount of at least 150 times as much as the TOC production speed of the photoresist itself is introduced, the concentration of TOC contained in wastewater from apparatus reaches 0.032 mg $\times$ 150 + 1 = 4.8 mg/L, since the amount of wastewater from apparatus is 1,000 cc/(min·$cm^2$). This means that the value is approximately the same level as that of the water quality standard concerning living environment provided by the Environment Agency, which is 5 mg/L to 10 mg/L. In a production plant, waste liquid from a large number of apparatus is generally treated at one time, but it is also desirable that the TOC amount in waste liquid from each piece of apparatus is kept to at most the value in compliance with the environmental standard. Accordingly, it is necessary to control the amount of acetic acid to be introduced into the treatment process to at most 150 times as high as the production speed of the substances produced attributed to the decomposition of the photoresist.

In case of comparing this Example with the conventional example (Fig. 25) in terms of the emission amount of TOC produced per unit surface area of a substrate in the entire process, the value is:

$$\text{Example / Conventional Example} = [(0.032 + 0.026)\ mg/(cm^2 \cdot min)]/[(0.032 + 5.0) mg/(cm^2 \cdot min)] = 1.1\%.$$

It is made clear that this Example achieves complete removal of the photoresist film with the load to environment of 1/100.

According to this Example, by keeping the substrate 2 to temperature higher than room temperature and controlling the temperature of the wet ozone-containing gas to be supplied to the photoresist film on the substrate 2 to temperature equal to or higher than that of the substrate 2, a proper acetic acid liquid film was formed on the substrate and the photoresist film was removed. Further, this Example proved that the Al film dissolution was actually prevented because the acidic substance generated by oxidation decomposition of the photoresist by ozone did not cause strong acidity in the acetic acid liquid film having a purity of 99.7 %. It was also proved that treatment of a substrate was achieved with an environmental load of about 1 % of that of the conventional method.

## EXAMPLE 7

In Example 6, acetic acid was used to prevent the ionization of the substances on the substrate, which is generated by oxidation of the photoresist film. But in this Example, experiments were carried out using acetone as a solvent. Since the boiling point of acetone is 51°C, the substrate was heated to 40°C. The gas sending tube 8a, the gas sending tube 8b, the gas sending tube 8c and the header 5 were heated to 50°C. After the respective temperature levels were stabilized, acetone and ozone-containing gas (ozone concentration: 200 g/$Nm^3$) which had been passed through acetone heated to 50°C and humidified by the humidifier 7 was supplied at a flow rate of 3,000 cc/minute. The vapor pressure of acetone in gas containing acetone vapor and ozone (hereinafter sometimes referred to as acetone- and ozone-containing gas) was adjusted to the saturated vapor pressure at 50°C.

The results of Example 7 is that the pH on the substrate surface after the photoresist removal was approximately neutral (pH = 5 to 6) in the range of residence time of 0.01 to 1.0 second and no change was observed in the Al film thickness. When the time for the complete removal by the wet ozone-containing gas at 90°C in Example 1 was set to be 1, the time for the complete removal by the acetone- and ozone-containing gas was shortened to be 0.7 to 0.8.

According to this Example, by keeping the substrate 2 to temperature higher than room temperature and controlling the temperature of the wet ozone-containing gas to be supplied to the photoresist film on the substrate 2 to temperature equal to or higher than that of the substrate 2, a proper acetone liquid film was formed on the substrate and the photoresist film was removed. Further, this Example proved that the Al film dissolution was actually prevented because the acidic substance generated by oxidation decomposition of the photoresist by ozone did not cause strong acidity in the acetone liquid film.

In Examples 6 and 7, acetic acid and acetone were used in order to prevent the ionization of the substances generated by oxidation of the photoresist film on the substrate. However, the same effect was observed in case of using methanol, ethanol, propanol, acetonitrile, carbon tetrachloride, chloroform and the like. This is because the acidic substance generated by the resist removal has low ionization constant for the above-described solvents and thus the pH on the substrate surface is not decreased even if the acidic substance is dissolved.

EXAMPLE 8

In Examples 6 and 7, a solvent which prevents the ionization of the substances generated by oxidation of photoresist film on the substrate was used. However, when such a solvent has reactivity to ozone, the resist removal property was deteriorated owing to the consumption of ozone.

In this Example, chloroform or carbon tetrachloride was used in place of acetic acid or acetone. In the treatment using ozone gas containing chloroform or carbon tetrachloride, the time for complete removal is shown in Table 5 (the time for complete removal of the resist film by acetic acid- and ozone-containing gas in Example 6 was set to be 1).

According to "Theory and Practice of Ozone Use", p. 274, published by Realize Co., the reaction speeds of ozone with carbon tetrachloride and chloroform are described as 0.007 $s^{-1}M^{-1}$ and 2.1 $s^{-1}M^{-1}$, respectively. In case of introducing chloroform, ozone is supposedly consumed by reaction of ozone with chloroform. Similar tendency is observed in case of using solvents such as methanol, ethanol and propanol as well as in case of using chloroform.

In this way, a solvent having low reactivity with ozone is preferable as a solvent to be introduced to prevent the ionization of acidic substance produced by resist oxidation decomposition.

EXAMPLE 9

Examples 1 to 8 disclosed methods for treating a substrate in case of using A1 as the wiring material of the substrate. Since A1 can form a stable oxide in a pH range of 4 to 9 as described in the section of the background art, the pH was adjusted to the range of 4 to 9 by controlling flow rate of the additive gas and the like in Examples 1 to 5. However, since different metals have different stable regions, it is necessary to arrange such a condition as the amount of additive gas in consideration of those stable regions.

Table 6 shows the pH ranges in which various metals can form stable oxide when exposed to ozone-containing water.

TABLE 6

| metal | pH range |
|---|---|
| aluminium | 4~9 |
| copper | 7~13 |
| nickel | at least 7 |
| tungsten | at most 4 |
| iron | at least 2 |
| zinc | 8~11 |
| indium | 5~11 |
| titanium | all |
| magnesium | at least 12 |

In this Example, films of various metals shown in Table 6 were formed and similarly investigated in place of Al metal in Example 1.

After treating a substrate by wet ozone-containing gas and ammonia gas for one minute, the decomposed photoresist film was removed by supplying pure water of 55°C to the substrate 2 at a flow rate of 3,000 cc/minute. A series of the steps of 1-minute substrate treatment and the rinsing with pure water was repeated until the photoresist film on the substrate 2 was completely removed.

The flow rate of ammonia gas was changed and the film thickness of various metals after the complete removal of the photoresist by wet ozone-containing gas and ammonia gas was measured using a stylus type film thickness profilometer. Further, after the treatment with wet ozone-containing gas, the pH on the surface of the substrate was measured just before the rinsing step with pure water.

In case of tungsten and titanium, no metal film corrosion was observed even if the amount of ammonia supply was 0 since stable oxides are formed even at pH 2.

Regarding other metals, the pH on the surface of the substrate after the substrate treatment varied in accordance with the change in the ammonia gas flow rate, and corrosion was prevented when the pH entered the stable range of each metal. For example, in case of magnesium, the ammonia flow rate necessary for the stabilization was about 2,000 cc/minute, which was the highest, because magnesium is stabilized in an alkaline state of at least pH 12. As described in Example 1, since the production speed of the acidic substance molecule produced by oxidation of the photoresist film is equal to the supply speed of the ammonia molecule supplied at an ammonia gas flow rate of 60 cc/min, the supply speed of ammonia molecule at the above flow rate of 2,000 cc/minute is about 33 times as high as the production speed of the acidic substance molecule. To prevent metal dissolution completely by introducing ammonia as described in Example 1, the flow rate of ammonia gas was at least 2,000 cc/minute for magnesium, at most 1,750 cc/minute for indium, 1,000 cc/minute for tungsten, 1,750 cc/minute for zinc and 1,500 cc/minute for copper.

According to this Example, by keeping the substrate 2 to temperature higher than room temperature and by adjusting the temperature of the wet ozone gas supplied to the photoresist film on the substrate 2 to at least the temperature of the substrate 2, a proper water film was formed on the substrate and the photoresist film was removed. Further, it was also proved that the dissolution of film of other metals attributed to the acidic substance produced by oxidation decomposition of the photoresist due to ozone could be prevented by controlling the pH on the surface of the substrate 2 with adjusting the flow rate of ammonia gas.

## EMBODIMENT 2

Differently from Embodiment 1 which mainly describes the case of small size substrates, this Embodiment gives a detailed explanation of a method of treating large size substrates such as a substrate for LCD. Fig. 18 is a schematic view illustrating the constitution of an apparatus for treating a substrate according to Embodiment 2, which works effectively in case of treating a large size substrate such as LCD substrate.

This apparatus for treating a substrate comprises a pre-heating unit 51 for the substrate 2, an ozone treatment unit 52, a pure water rinsing unit 53 and a drying unit 54. Rollers 55 continuously transport the substrate 2 in one direction inside the apparatus and the photoresist film previously formed on the substrate 2 is removed. Ozone gas generated by an ozone generator 6 becomes wet gas by a humidifier 7 and is introduced into the treatment units, together with an additive gas produced in an additive gas generator 18.

A linear nozzle 56 having a length equal to the width of the substrate 2 (in other words, the length in direction rectangular to the transportation direction of the substrate) is installed in the ozone treatment unit 52 and the wet ozone-containing gas and the additive gas are sprayed to the substrate 2 through the nozzle 56 to remove the photoresist on the substrate 2. Regarding the opening part of the nozzle 56, a slit type nozzle or a nozzle with a large number of fine holes can be employed.

The opening width of the slit type nozzle is preferably in a range of 0.1 to 1 mm. On the other hand, in case of the nozzle with a large number of holes, it is preferable to arrange a large number of holes having a diameter of 0.1 to 1 mm at intervals of at most 10 mm.

When wet ozone-containing gas of high temperature arrives at the nozzle 56 and temperature of the nozzle 56 is low, water turns into dew inside the nozzle, there is fear of short supply of water to the substrate 2 or dripping of condensed water on the substrate 2. Therefore, the temperature of the nozzle 56 must be equal to or higher than the ozone gas temperature. A heating means for preventing dew formation are installed also in the humidifier for humidifying the ozone-containing gas and a gas sending tube connecting the humidifier and the nozzle 56 in the same manner as in Embodiment 1 though there is no illustration in the figure.

The time from the mixing of wet ozone-containing gas with the additive gas to the arrival of the gas mixture to the supply port of the nozzle 56 can be adjusted by changing the distance from the mixing point to the supply spot. By keeping the substrate 2 to temperature higher than room temperature and by adjusting the temperature of the wet ozone gas supplied to the photoresist film on the substrate 2 to at least the temperature of the substrate 2, a proper water film was formed on the substrate and the photoresist film was removed. Further, by controlling the supply amount of the additive gas and the mixing duration of the additive gas with the wet ozone-containing gas, the pH on the surface of the substrate 2 was increased, and thus it was possible to prevent dissolution of the wiring metal attributed to the acidic substance produced by oxidation decomposition of the photoresist by ozone.

## EMBODIMENT 3

Embodiment 3 of the invention is carried out by using the apparatus for treating a substrate described in Embodiment 2, with providing a plurality of nozzles for the apparatus to supply the wet ozone-containing gas and the additive gas to substrate 2 separately.

Fig. 19 shows an enlarged view of the ozone treatment unit 52 (Fig. 18) shown in Fig. 18. The ozone gas generated by the ozone generator 6 becomes wet gas by the humidifier 7 and introduced into the treatment units, together with an additive gas produced in an additive gas generator 18. Fig. 19 shows the case of using three nozzles 61 for the wet ozone-containing gas and three nozzles 62 for the additive gas. The additive gas is introduced for the purpose of neutralizing the acidic substance produced at the time of decomposition of the photoresist molecules by the wet ozone gas. Therefore, more effective results can be obtained when the distance d 1 between the wet ozone-containing gas nozzle and the additive gas nozzle is shorter. The distance d is preferably in a range of 10 to 300 mm.

On the other hand, it is more effective to define the distances d2 evenly among the ozone nozzles in the ozone treatment units.

By supplying the wet ozone-containing gas and the additive gas separately through different nozzles, the interaction between the wet ozone-containing gas and the additive gas can beminimized, which occurs before arriving at the surface of the substrate. By adjusting the nozzle distances d1 and d2 properly, dissolution of the wiring metal on the substrate can be prevented with maintaining photoresist removal capability high. Further, though the case of using respective three nozzles was shown in Fig. 19, the number of each nozzle should be determined depending on the size of the substrate and the size of the ozone treatment units.

## EMBODIMENT 4

Embodiment 4 of the invention is carried out by using the apparatus for treating a substrate described in Embodiment 2, and an impurity removal tower 58 is further installed in the rear stage of the ozone generator 6 to supply wet ozone-containing gas to the substrate as illustrated in Fig. 20.

This apparatus for treating a substrate comprises a preheating unit 51 for a substrate 2, an ozone treatment unit 52, a pure water rinsing unit 53 and a drying unit 54. Rollers 55 continuously transport the substrate 2 in one direction inside the apparatus and the photoresist film previously formed on the substrate 2 is removed. Ozone gas generated by the ozone generator 6 becomes wet gas by a humidifier 7 and is introduced into the treatment units, together with an additive gas produced in an additive gas generator 18.

In case of treating a large size LCD substrate, the amount of the photoresist film, which is an object to be treated is increased, and therefore the amount of ozone gas introduced to the ozone treatment unit is also increased. As a typical example of a large volume ozone generator, there is an electric discharge type ozone generation method. As to the method, it is known that generation efficiency is improved when a small amount of nitrogen is added to oxygen which is a raw material gas. In case of the electric discharge type ozone generation method using nitrogen gas, nitrogen oxide is produced along with ozone generation, indicating a possibility of corrosion at the constituent material of the photoresist film treatment apparatus and the wiring metal on the substrate. Since nitrogen dioxide has high solubility in water and is easily ionized to generate nitrate ion, it is likely that strong acidity is caused.

In addition, there are some of electric discharge type ozone generators which generate metal ions and fine particles due to sputtering phenomenon in electrodes. The intake of impurity metals to the LCD substrate sometimes causes serious effects on products.

The constitution of the impurity removal tower is shown in Fig. 21. Pure water is supplied to a treatment tower 71 at a constant flow rate through a pure water pump 73 and excess pure water is discharged out of an overflow port 74. The ozone-containing gas generated by the ozone generator 6 is supplied to the treatment tower 71 and sufficiently brought into contact with pure water by a stirrer 72, so that impurities such as nitrogen oxide and metal ions are dissolved in the pure water and removed almost perfectly.

A tube from the overflow port 74 to a water discharge channel is once extended downward and then turned back upward as shown in the figure. According to this, the tube is provided with a structure in which water pole is always kept to be at a constant height (L (mm)) in the tube. When the flow pressure of the ozone gas is p [mm$H_2O$], L [mm] is preferably at least 2p [mm].

## EMBODIMENT 5

Embodiment 5 of the invention is carried out by employing a voltage adjuster in place of the additive gas generator as described in Embodiment 1. As illustrated in Fig. 22, the potential of the metal wiring is kept constant by leading out a conducting wire from the wiring metal on the substrate 2 and connecting the conducting wire to the voltage adjuster 81 to prevent corrosion of the metal wiring.

Another reason for the corrosion of metal in ozone-containing water in addition to the pH discussed in detail above include high oxidation potential (at least 1.5 V) of ozone-containing water. Generally, when metal is exposed to ozone-containing water, the potential of the metal surface is increased to the high oxidation potential of ozone-containing water to promote corrosion. On the other hand, according to ATLAS OF ELECTROCHEMICAL EQUILIBRIA IN AQUEOUS SOLUTIONS (Pergamon Press 1966), almost all metals do not produce oxide film and can be stabilized in a state of pure metal when the redox potential is at most -2.0 V.

## EXAMPLE 10

Example 10 was carried out with changing the voltage of the voltage adjuster 81 in Embodiment 5. A series of steps of 1-minute substrate treatment and the rinsing with pure water was repeated in the same manner as Example 1 until the photoresist film on the substrate 2 was completely removed.

An aluminum film, a chromium film and a molybdenum film were separately formed on substrates whose surfaces were cleaned in a thickness of 200 nm. Thereafter, a 1,450 nm-thick photoresist film which was an object to be treated was formed on each substrate. The set value of the voltage adjuster was changed in a range of +3 to -3 V and the Al film thickness after complete removal of the photoresist by wet ozone-containing gas was measured by using a stylus type film thickness profilometer.

The film thickness measured values of the respective metals are shown in Fig. 11 as the results obtained in Example 10. Since treatment was carried out only with the wet ozone-containing gas in this Example, the pH on each substrate measured just before the rising step after the ozone treatment was about pH 2. When the voltage set value was positive, preventing effect on metal corrosion was not observed. When the voltage set value was negative, it is found that corrosion was prevented in a range near the redox potential of the respective metals.

According to this Example, by keeping the temperature of the substrate 2 to higher than room temperature and by adjusting the temperature of the wet ozone gas supplied to the photoresist film on the substrate 2 to at least the temperature of the substrate 2, a proper water film was formed on the substrate and the photoresist film was removed. Further, it was also proved that the metal film dissolution attributed to the acidic substance produced by oxidation decomposition of the photoresist due to ozone could be prevented by controlling the potential of wiring on the substrate.

REFERENCE EXAMPLE 1

In Reference Example 1, investigation was made as in Example 1 with changing the pH on the substrate surface on purpose by using additive gas but without forming photoresist film on the substrate previously.

A surface-cleaned substrate 2 (a 0.7 mm-thick glass substrate on which a 200 nm-thick Al film was already formed) was cut into a size of 100 mm × 100 mm. The substrate was placed on the plate heater in the treatment chamber 1 with the Al film upward and heated to 73°C. The gas sending tube 8a, the gas sending tube 8b, the gas sending tube 8c and the header 5 were heated to 90°C. After the respective temperature levels were stabilized, wet ozone-containing gas (ozone concentration: 200 g/$Nm^3$) passed through pure water heated to 90°C and humidified by the humidifier 7 was supplied at a flow rate of 5,000 cc/minute. The humidity of the wet ozone-containing gas wasadjusted to the saturated vapor concentration at 90°C. Nitrogen dioxide gas was used as acidic substance added to adjust the pH on the substrate and the gas flow rate was adjusted by a mass flow controller. Nitrogen dioxide gas and wet ozone-containing gas were mixed at a point d = 100 mm before the supply port of a header 5 and supplied to the surface of the substrate 2.

After treating the substrate by wet ozone-containing gas and nitrogen dioxide gas for 1 minute, pure water of 55°C was supplied to the substrate 2 at a flow rate of 3,000 cc/minute to clean the same.

The flow rate of nitrogen dioxide was changed in a range of 0 to 200 cc/minute and the Al film thickness after substrate treatment with wet ozone-containing gas and nitrogen dioxide gas was measured by a stylus type film thickness profilometer.

The results of Reference Example 1 are shown in Fig. 26. When the flow rate of nitrogen dioxide is at least 40 cc/minute, the pH on the substrate was decreased to at most pH 4 and decrease of film thickness owing to the Al film corrosion was observed. On the other hand, when the flow rate of nitrogen dioxide gas was 0 cc/minute, the pH on the substrate was about pH 7 and no change was observed in Al film thickness.

Corrosion of Al film was not observed when nitrogen dioxide gas was not used. This means that the Al film corrosion observed in Examples 1 to 3 was not caused by the wet ozone-containing gas itself. In other words, it was proved that the cause of the complete dissolution of the Al film at an ammonia gas flow rate of 0 cc/minute as shown in the results of Example 1 (Fig. 2) was the pH decrease on the substrate attributed to the acidic substance produced by the reaction of the wet ozone-containing gas and the photoresist.

REFERENCE EXAMPLE 2

In Reference Example 2, investigation was made as in Example 1 with adjusting the pH on the substrate surface to pH 2 by using additive gas but without forming photoresist film on the substrate previously. Further, experiments were also made as to the cases where the temperature of the substrate was changed in a range of 50 to 85°C.

As shown in Fig. 1, a surface-cleaned substrate 2 (a 0.7 mm-thick glass substrate on which a 200 nm-thick Al film was already formed) was cut into a size of 100 mm × 100 mm. The substrate was placed on the plate heater 4 in the treatment chamber 1 with the Al film upward and heated to a prescribed temperature. The gas sending tube 8a, the gas sending tube 8b, the gas sending tube 8c and the header 5 were heated to 90°C. After the respective temperature levels were stabilized, wet ozone-containing gas (ozone concentration: 200 g/$Nm^3$) passed through pure water heated to 90°C and humidified by the humidifier 7 was supplied at a flow rate of 5,000 cc/minute. The humidity of the wet ozone-containing gas was adjusted to the saturated vapor concentration at 90°C. Nitrogen dioxide gas was used as acidic gas added to adjust the pH on the substrate and the gas flow rate was adjusted by a mass flow controller 21. The nitrogen dioxide gas and the wet ozone-containing gas were mixed at a point d = 100 mm before the supply port of the header 5 and supplied to the surface of the substrate 2.

After treating the substrate by wet ozone-containing gas and nitrogen dioxide gas for 1 minute, pure water of 55°C was supplied to the substrate 2 at a flow rate of 3,000 cc/minute to clean the same.

The set temperature of the substrate was changed to 50°C, 70°C and 85°C and the Al film thickness after substrate treatment with wet ozone-containing gas and nitrogen dioxide gas was measured by a stylus type film thickness profilometer. Generally, the amount of water which condenses on the substrate is increased as the difference of the substrate temperature and the wet gas temperature becomes wide. Therefore, the flow rate of the nitrogen dioxide gas was increased by using a mass flow controller so as to adjust the pH on the substrate surface to be pH 2 before the rinsing with pure water after 1-minute substrate treatment.

The results of Reference Example 2 are shown in Table 7. The table shows the correlation between the temperature of the substrate to be treated and the aluminum film thickness after the treatment (at pH = 2). It is found that the film is dissolved by more than half of the initial film thickness, i.e., 200 nm for 1-minute treatment at 70°C. When the substrate temperature was 50°C, the Al film showed little decrease in film thickness even after 1-minute treatment using wet ozone-containing gas and nitrogen dioxide gas. Thus, it was proved that the lowering of the substrate temperature was effective in preventing the Al film corrosion.

However, in case of oxidation decomposition of the photoresist film by using wet ozone-containing gas as in Examples 1 to 3, the oxidation decomposition speed is probably decreased with the decrease of the substrate temperature.

TABLE 7

| substrate temperature (°C) | Al film thickness (nm) |
|---|---|
| 50 | 160 |
| 70 | 80 |
| 85 | 12.5 |

<u>INDUSTRIAL APPLICABILITY</u>

The first process for treating a substrate of the invention is a process for treating a substrate which comprises removing organic pollutant on the surface of the substrate using mixed gas of wet-ozone containing gas wetted by steam and basic gas, wherein a supply speed of basic gas molecule is controlled to at most 100 times as high as the production speed of molecule of acidic substance produced by oxidation reaction of the organic pollutant. According to this, it becomes possible to maintain the pH value on the substrate to be treated in such a range that wiring metal previously formed on the substrate is present in a stable state and therefore prevention of the corrosion of the wiring metal is achieved.

The second process for treating a substrate of the present invention is a process in which a volatile substance is introduced as the basic gas. According to this, it becomes possible to maintain the pH value on the substrate to be treated in such a range that wiring metal previously formed on the substrate is present in a stable state and therefore prevention of the corrosion of the wiring metal is achieved.

The third process for treating a substrate of the present invention is a process in which ammonia gas is used as thebasic gas. According to this, it becomes possible to maintain the pH value on the substrate to be treated in such a range that wiring metal previously formed on the substrate is present in a stable state and therefore prevention of the corrosion of the wiring metal is achieved.

The fourth process for treating a substrate of the present invention is a process in which ammonia gas passed through saturated ammonia is used as the basic gas. According to this, it becomes possible to maintain the pH value on the substrate to be treated in such a range that wiring metal previously formed on the substrate is present in a stable state and therefore prevention of the corrosion of the wiring metal is achieved.

The fifth process for treating a substrate of the present invention is a process in which a non-volatile substance is used as the basic gas. According to this, it becomes possible to maintain the pH value on the substrate to be treated in such a range that wiring metal previously formed on the substrate is present in a stable state and therefore prevention of the corrosion of the wiring metal is achieved.

The sixth process for treating a substrate of the present invention is a process in which TMAH (tetramethylammonium hydroxide) is used as the non-volatile substance. According to this, it becomes possible to maintain the pH value on the substrate to be treated in such a range that wiring metal previously formed on the substrate is present in a stable state and therefore prevention of the corrosion of the wiring metal is achieved.

The seventh process for treating a substrate of the present invention is a process in which the mixing duration from the mixing of the basic gas molecule and the wet ozone-containing gas to the arrival of the gas mixture at the substrate to be treated is controlled to at most 10 seconds. According to this, it becomes possible to maintain the pH value on the substrate to be treated in such a range that wiring metal previously formed on the substrate is present in a stable state and therefore prevention of the corrosion of the wiring metal is achieved.

The eighth process for treating a substrate of the present invention is a process for treating a substrate which comprises removing organic pollutant on the surface of the substrate using wet ozone-containing gas wetted by a treatment liquid, wherein a solvent capable of preventing ionization of acidic substance produced by the oxidation reaction of the organic pollutant is used as the treatment liquid. According to this, it becomes possible to maintain the pH value on the substrate to be treated in such a range that wiring metal previously formed on the substrate is present in a stable state and therefore prevention of the corrosion of the wiring metal is achieved.

The ninth process for treating a substrate of the present invention is a process in which a solvent having low reactivity to ozone is used as the treatment liquid. According to this, it becomes possible to maintain the pH value on the substrate to be treated in such a range that wiring metal previously formed on the substrate is present in a stable state and therefore prevention of the corrosion of the wiring metal is achieved.

The tenth process for treating a substrate of the present invention is a process in which acetic acid or acetone is used as thetreatment liquid. According to this, it becomes possible to maintain the pH value on the substrate to be treated in such a range that wiring metal previously formed on the substrate is present in a stable state and therefore prevention of the corrosion of the wiring metal is achieved.

The eleventh process for treating a substrate of the present invention is a process in which the supply speed of molecule of the solvent is controlled to at most 150 times as high as the production speed of molecule of the acidic substance produced by the oxidation reaction of the organic pollutant. According to this, it becomes possible to maintain the pH value on the substrate to be treated in such a range that wiring metal previously formed on the substrate is present in a stable state and therefore prevention of the corrosion of the wiring metal is achieved.

The twelfth process for treating a substrate of the present invention is a process in which voltage of wired metal previously formed on the substrate is adjusted. According to this, it becomes possible to maintain the potential on the substrate to be treated within a redox potential range that wiring metal previously formed on the substrate is present in a stable state and therefore prevention of the corrosion of the wiring metal is achieved.

The first apparatus for treating a substrate of the present invention comprises a substrate heating means for keeping a substrate at temperature higher than room temperature, a wetting means for obtaining wet ozone-containing gas by wetting, with a treatment liquid, ozone-containing gas generated by an ozone generator, a supplying means for supplying the wet ozone-containing gas to substance to be treated on the surface of the substrate, a gas sending tube for connecting the wetting means and the supplying means, a gas heating means for heating each of the wetting means, the supplying means and the gas sending tube to temperature equal to or higher than that of the substrate, and a supplying means for supplying a basic gas-containing gas to the substance to be treated on the surface of the substrate. According to this, it becomes possible to maintain the pH on the substrate to be treated in such a range that wiring metal previously formed on the substrate is present in a stable state and therefore prevention of the corrosion of the wiring metal is achieved.

The second apparatus for treating a substrate of the present invention further comprises a removing means for removing undesirable impurities generated from the ozone generator between the ozone generator and the wetting means for wetting the ozone-containing gas. According to this, it becomes possible to maintain the pH on the substrate to be treated in such a range that wiring metal previously formed on the substrate is present in a stable state and therefore prevention of the corrosion of the wiring metal is achieved.

The third apparatus for treating a substrate of the present invention comprises a substrate heating means for keeping a substrate at temperature higher than room temperature, a wetting means for obtaining wet ozone-containing gas by wetting, with a treatment liquid, ozone-containing gas generated by an ozone generator, a supplying means for supplying the wet ozone-containing gas to substance to be treated on the surface of the substrate, a gas sending tube for connecting the wetting means and the supplying means, a gas heating means for heating each of the wetting means, the supplying means and the gas sending tube to temperature equal to or higher than that of the substrate, and a controlling means capable of adjusting the potential of a metal wiring previously formed on the substrate. According to this, it becomes possible to maintain the potential on the substrate to be treated within a redox potential range that wiring metal previously formed on the substrate is present in a stable state and therefore prevention of the corrosion of the wiring metal is achieved.

## Claims

**1.** A process for treating a substrate by removing organic pollutant on the surface of the substrate using mixed gas of basic gas and wet ozone-containing gas wetted by steam, wherein a supply speed of basic gas molecule is at most 100 times as high as the production speed of molecule of acidic substance produced by oxidation reaction of the organic pollutant.

**2.** The process for treating a substrate of Claim 1, wherein a volatile substance is introduced as the basic gas.

**3.** The process for treating a substrate of Claim 2, wherein the volatile substance is ammonia gas.

**4.** The process for treating a substrate of Claim 3, wherein the ammonia gas is passed through a saturated aqueous solution of ammonia.

**5.** The process for treating a substrate of Claim 1, wherein a non-volatile substance is introduced as the basic gas.

**6.** The process for treating a substrate of Claim 5, wherein the non-volatile substance is tetramethylammonium hydroxide.

**7.** The process for treating a substrate of Claim 1, wherein the mixing duration from the mixing of the basic gas molecule and the wet ozone-containing gas to the arrival of the gas mixture at the substrate to be treated is at most 10 seconds.

**8.** A process for treating a substrate by removing organic pollutant on the surface of the substrate using wet ozone-containing gas wetted by treatment liquid, which comprises using, as the treatment liquid, a solvent capable of preventing ionization of acidic substance produced by oxidation reaction of the organic pollutant.

**9.** The process for treating a substrate of Claim 8, wherein the treatment liquid is a solvent having low reactivity to ozone.

**10.** The process for treating a substrate of Claim 9, wherein the solvent having low reactivity to ozone is acetic acid or acetone.

**11.** The process for treating a substrate of Claim 8, wherein the supply speed of molecule of the solvent is at most 150 times as high as the production speed of molecule of the acidic substance produced by oxidation reaction of the organic pollutant.

**12.** A process for treating a substrate by removing organic pollutant on the surface of the substrate using wet ozone-containing gas wetted by treatment liquid, which comprises adjusting voltage of wired metal previously formed on the substrate.

**13.** An apparatus for treating a substrate comprising a substrate heating means for keeping a substrate at temperature higher than room temperature, a wetting means for obtaining wet ozone-containing gas by wetting, with a treatment liquid, ozone-containing gas generated by an ozone generator, a supplying means for supplying the wet ozone-containing gas to substance to be treated on the surface of the substrate, a gas sending tube for connecting the wetting means and the supplying means, a gas heating means for heating each of the wetting means, the supplying means and the gas sending tube to temperature equal to or higher than that of the substrate, and a supplying means for supplying basic gas-containing gas to the substance to be treated on the surface of the substrate.

**14.** The apparatus for treating a substrate of Claim 13, further comprising a removing means for removing undesirable impurities generated from the ozone generator between the ozone generator and the wetting means for wetting the ozone-containing gas.

**15.** An apparatus for treating a substrate comprising a substrate heating means for keeping a substrate at temperature higher than room temperature, a wetting means for obtaining wet ozone-containing gas by wetting, with a treatment liquid, ozone-containing gas generated by an ozone generator, a supplying means for supplying the wet ozone-containing gas to substance to be treated on the surface of the substrate, a gas sending tube for connecting the wetting means and the supplying means, a gas heating means for heating each of the wetting means, the supplying means and the gas sending tube to temperature equal to or higher than that of the substrate, and a controlling means capable of adjusting the potential of a metal wiring previously formed on the substrate.

FIG. 1

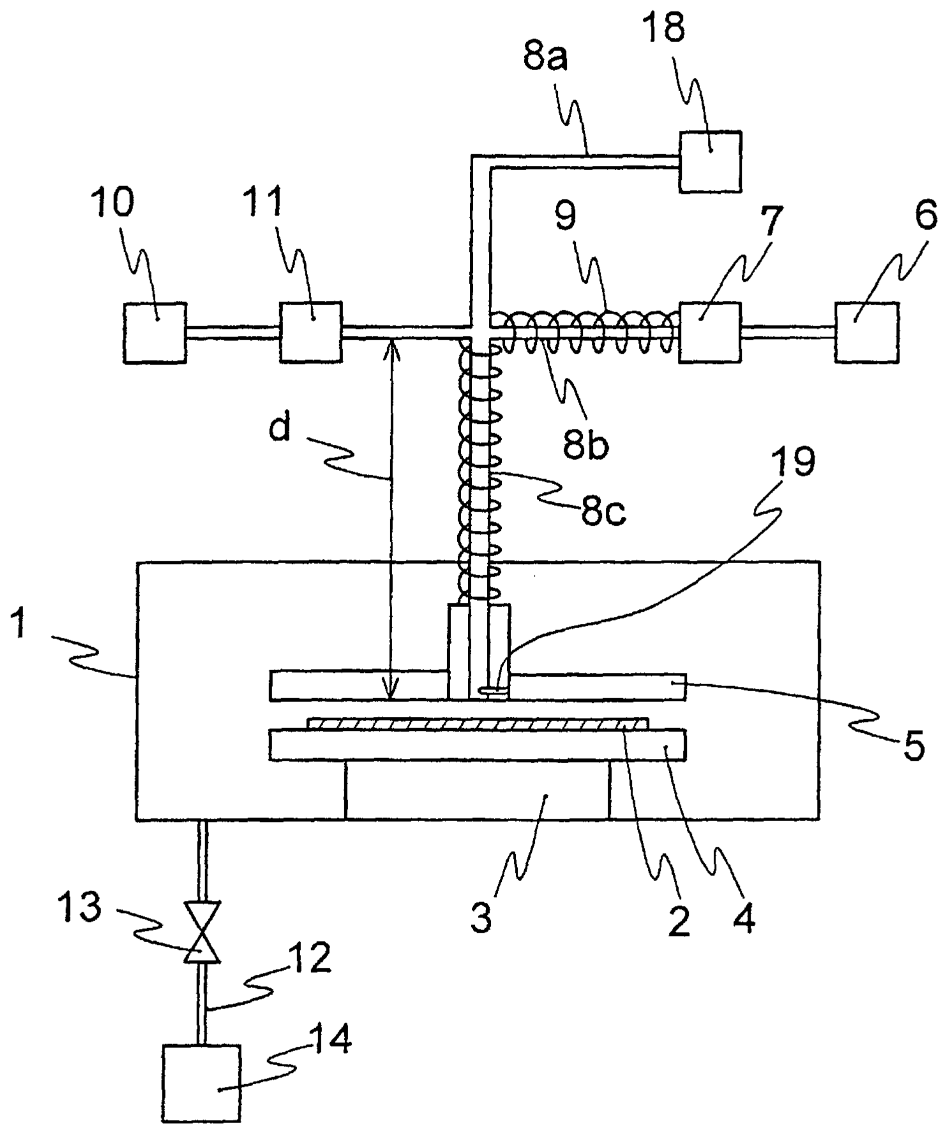

FIG. 2

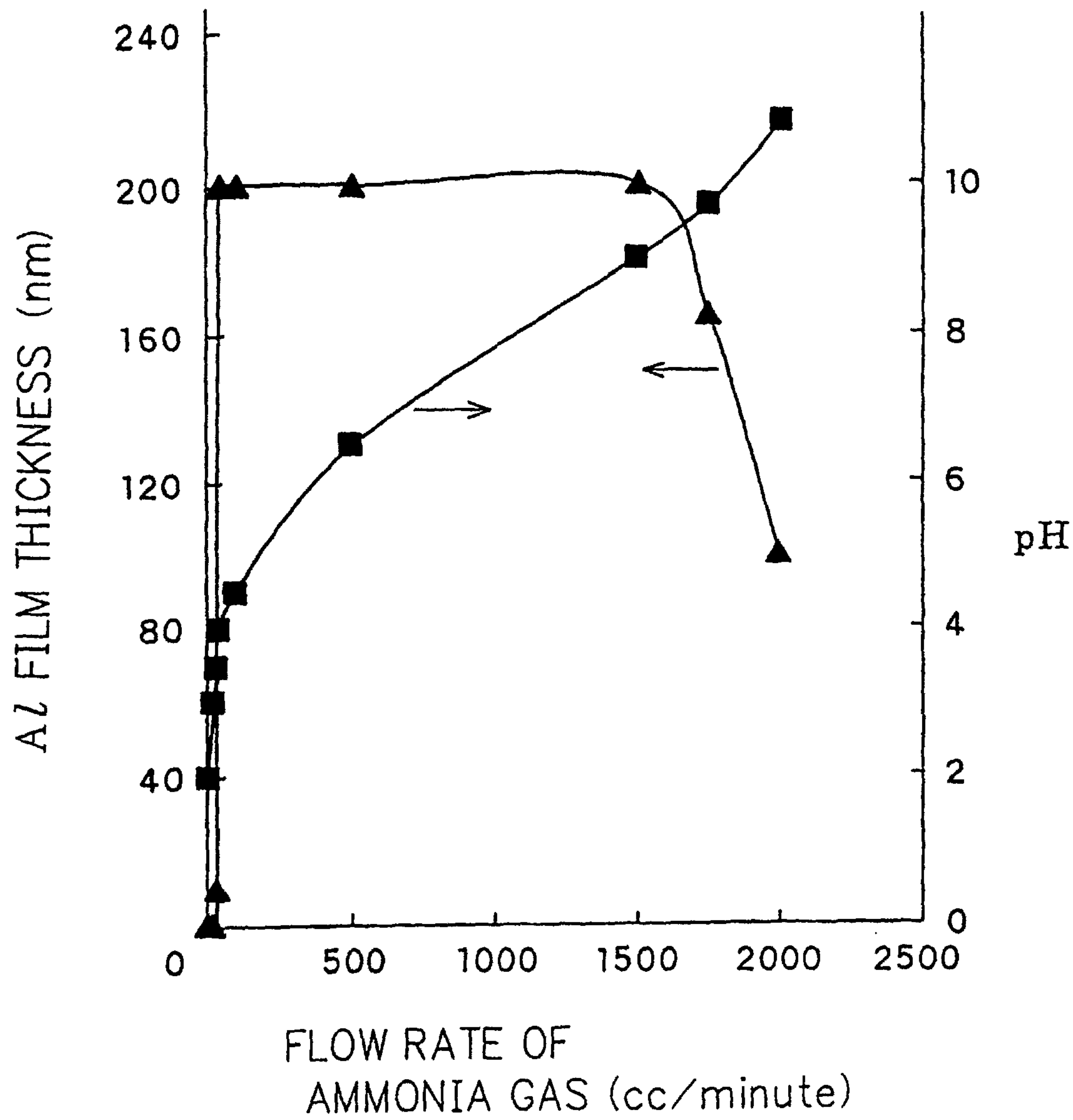
240
200
160
120
80
40
0
Al FILM THICKNESS (nm)
10
8
6
4
2
0
pH
500
1000
1500
2000
2500
FLOW RATE OF
AMMONIA GAS (cc/minute)

FIG. 3

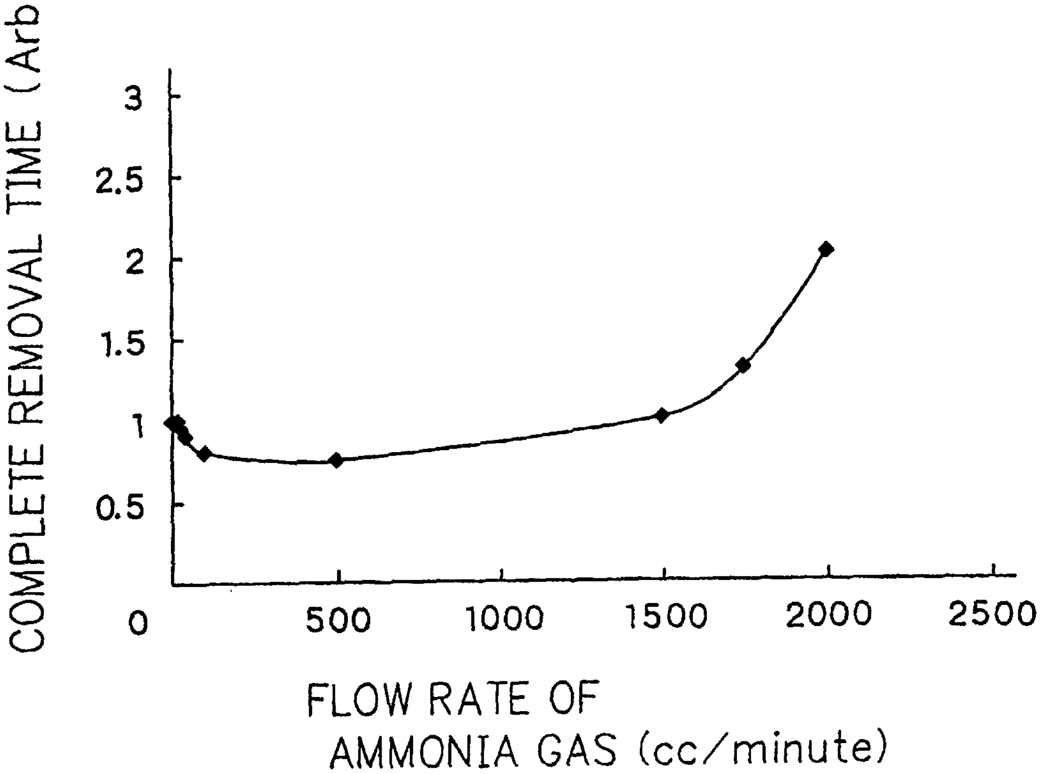
COMPLETE REMOVAL TIME (Arb)
3
2.5
2
1.5
1
0.5
0
500
1000
1500
2000
2500
FLOW RATE OF
AMMONIA GAS (cc/minute)

FIG. 4

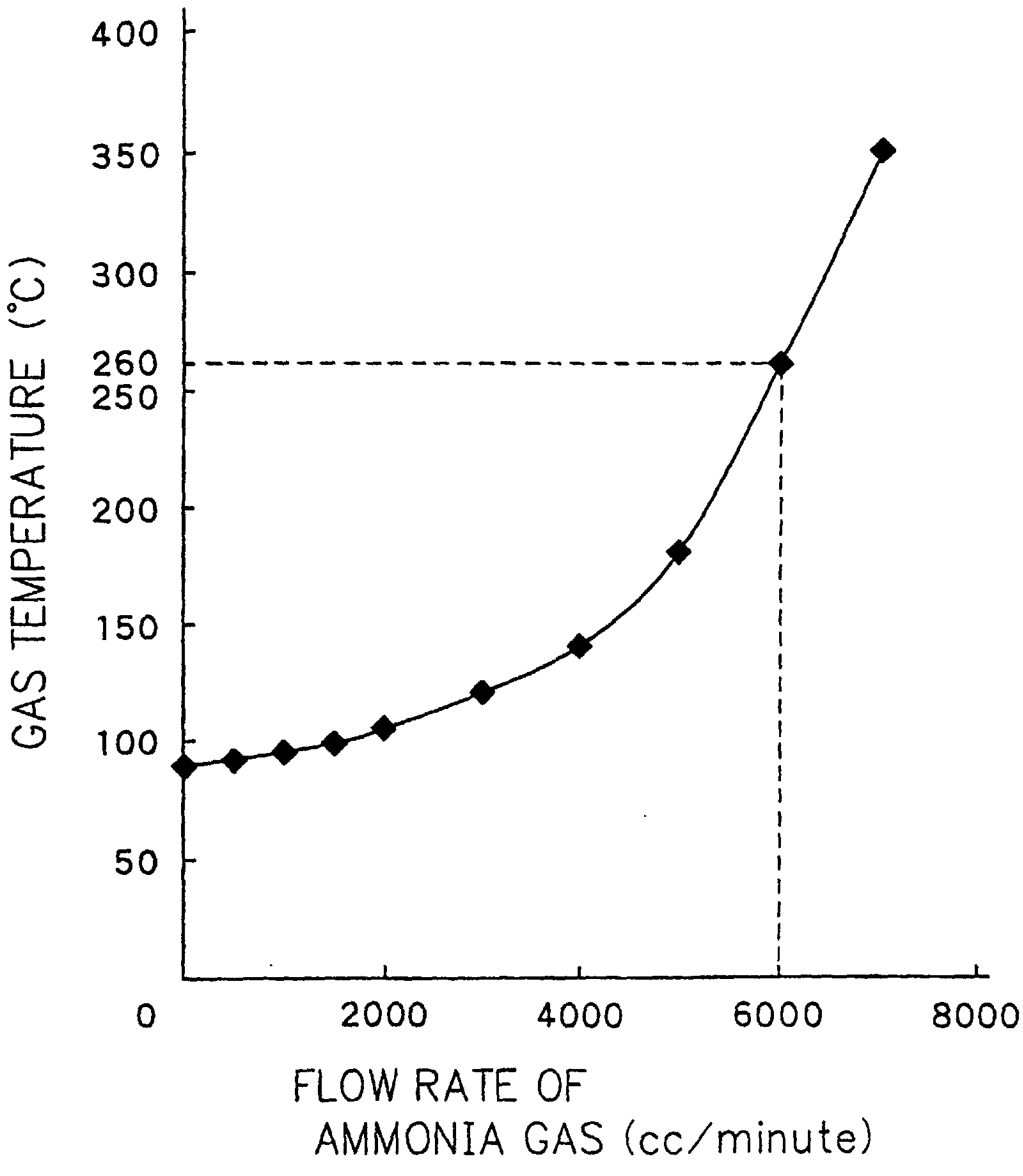
GAS TEMPERATURE (°C)
400
350
300
260
250
200
150
100
50
0
2000
4000
6000
8000
FLOW RATE OF
AMMONIA GAS (cc/minute)

FIG. 5

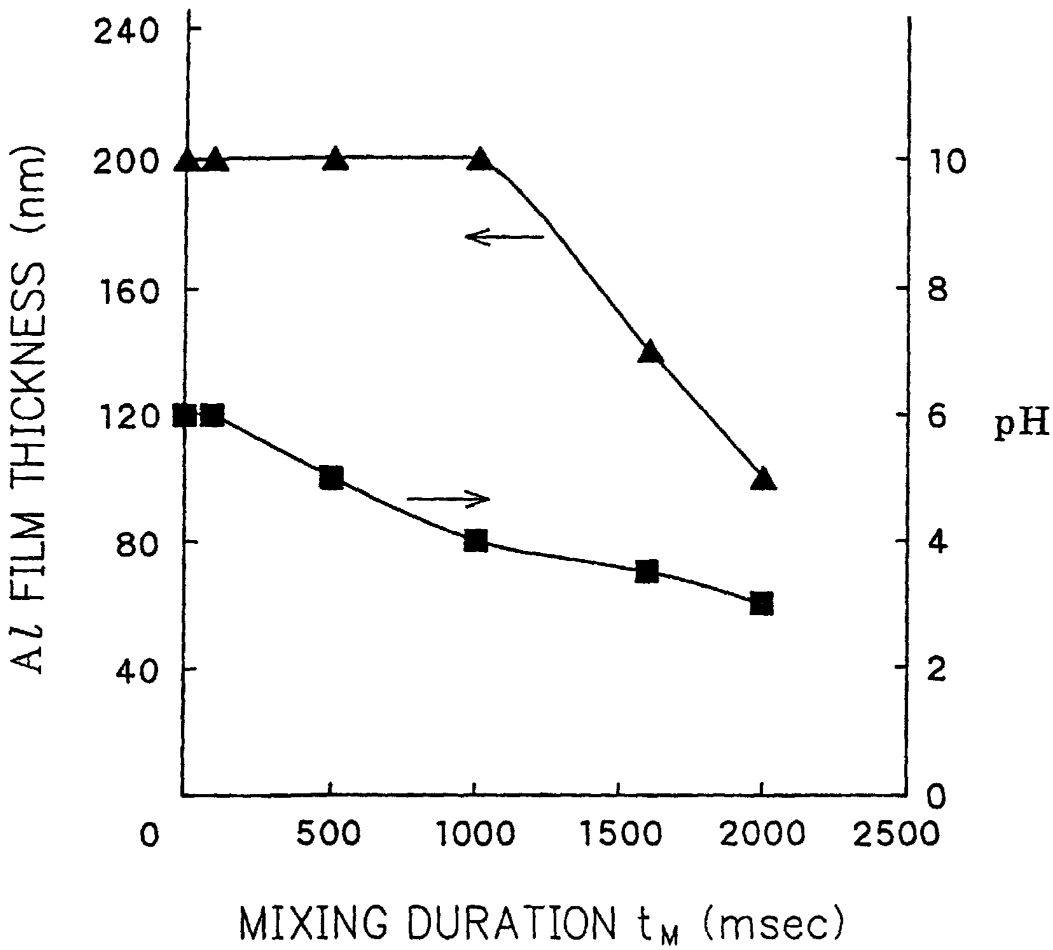
240
200
160
120
80
40
0
Al FILM THICKNESS (nm)
10
8
6
4
2
0
pH
0
500
1000
1500
2000
2500
MIXING DURATION $t_M$ (msec)

FIG. 6

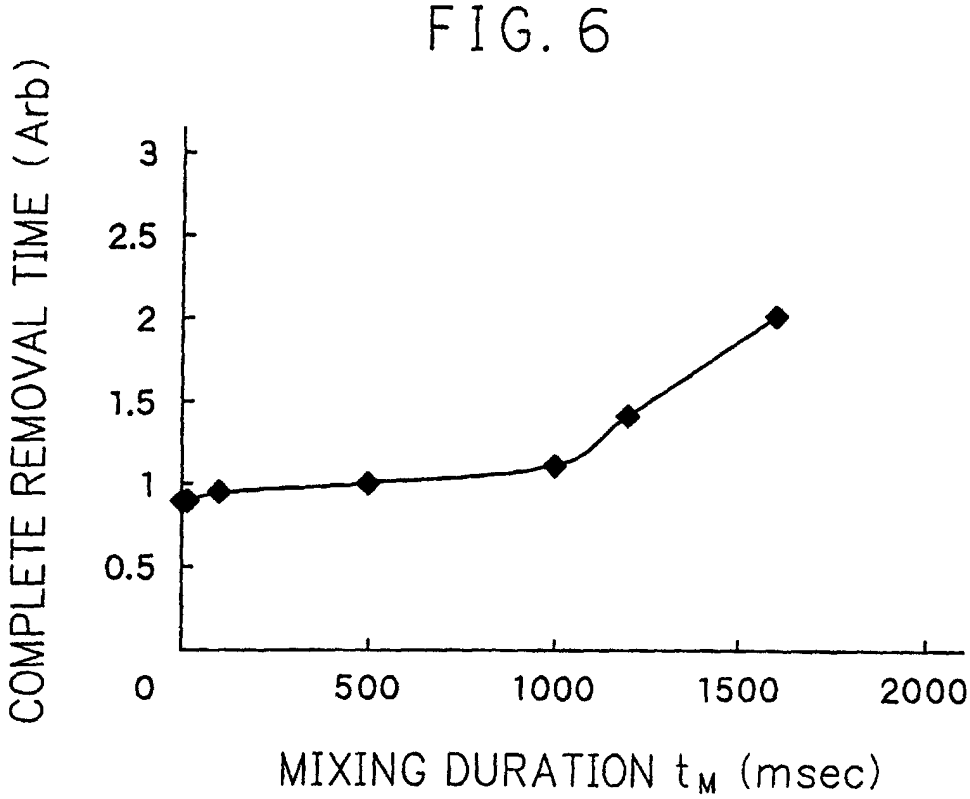
COMPLETE REMOVAL TIME (Arb)
3
2.5
2
1.5
1
0.5
0
500
1000
1500
2000
MIXING DURATION $t_M$ (msec)

FIG. 7

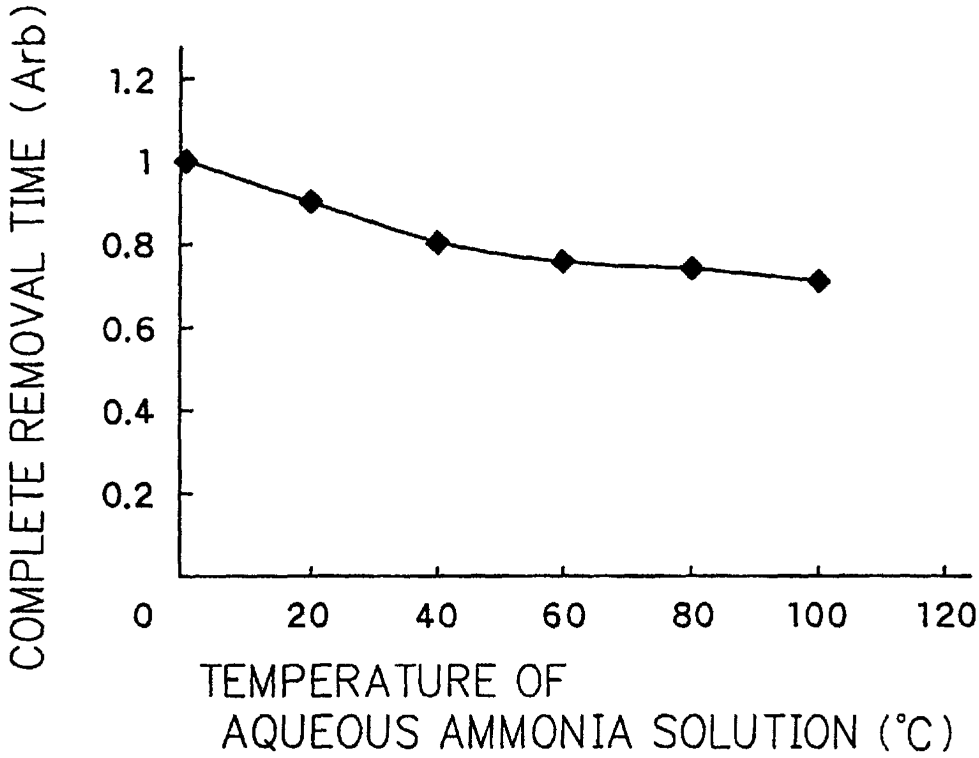
COMPLETE REMOVAL TIME (Arb)
1.2
1
0.8
0.6
0.4
0.2
0
20
40
60
80
100
120
TEMPERATURE OF
AQUEOUS AMMONIA SOLUTION (°C)

FIG. 8

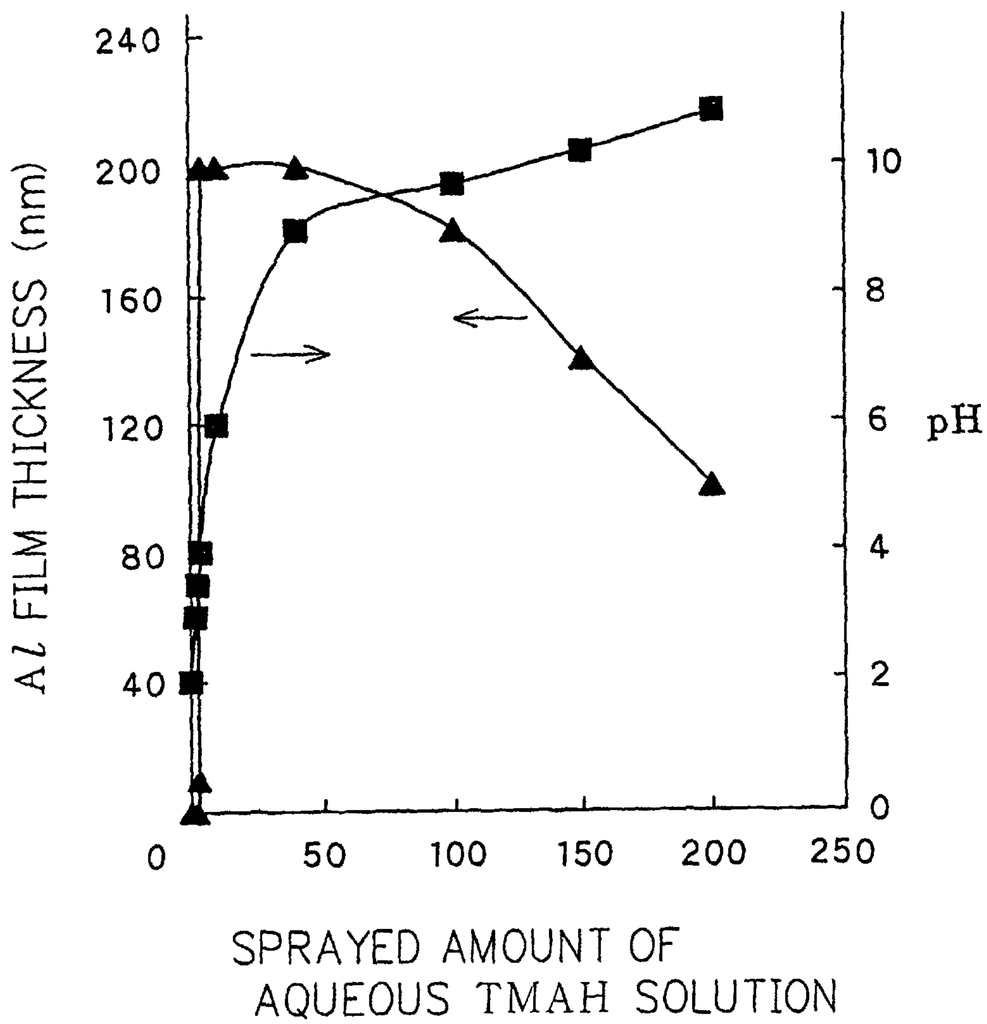
240
200
160
120
80
40
0
50
100
150
200
250
10
8
6
4
2
0
pH
Al FILM THICKNESS (nm)
SPRAYED AMOUNT OF AQUEOUS TMAH SOLUTION

FIG. 9

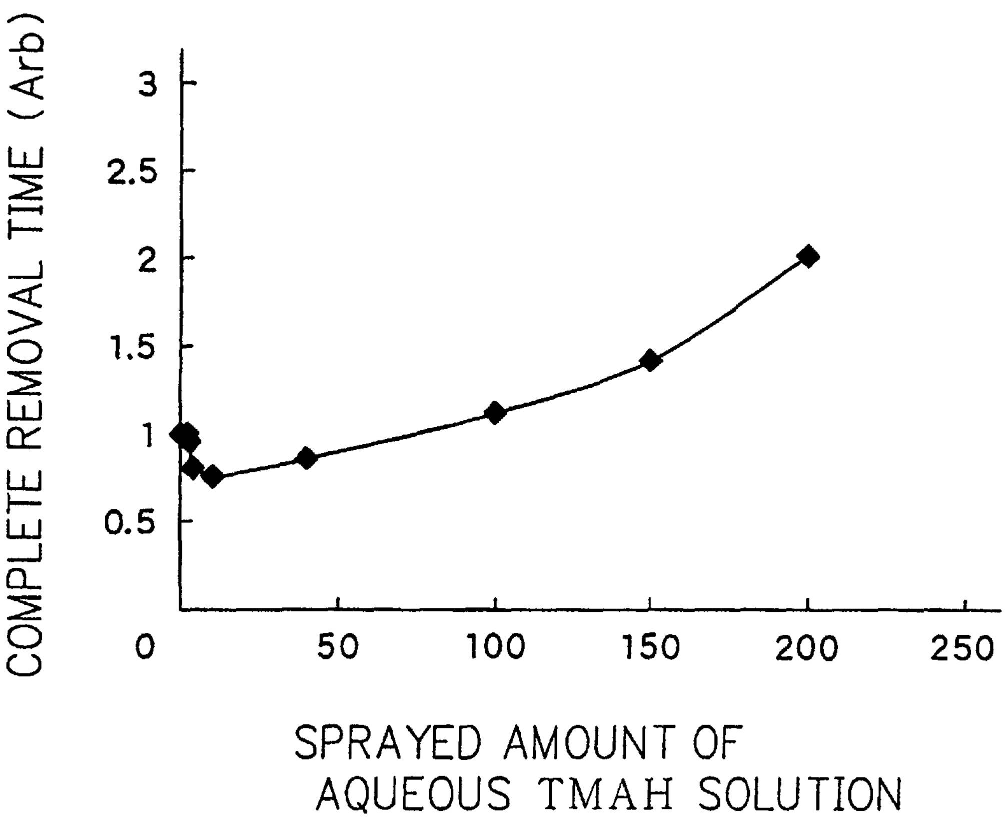
COMPLETE REMOVAL TIME (Arb)
3
2.5
2
1.5
1
0.5
0
50
100
150
200
250
SPRAYED AMOUNT OF
AQUEOUS TMAH SOLUTION

FIG. 10

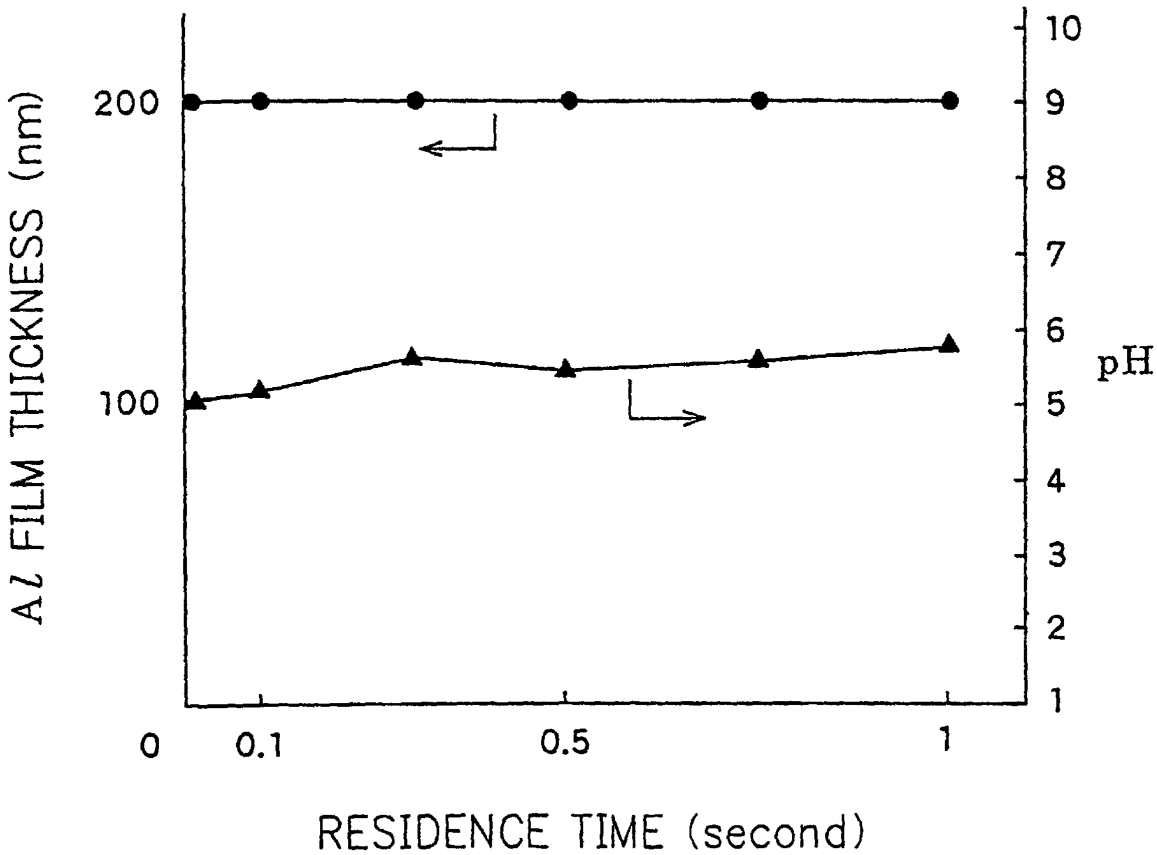
Aℓ FILM THICKNESS (nm)
200
100
10
9
8
7
6
5
4
3
2
1
pH
0
0.1
0.5
1
RESIDENCE TIME (second)

FIG. 11

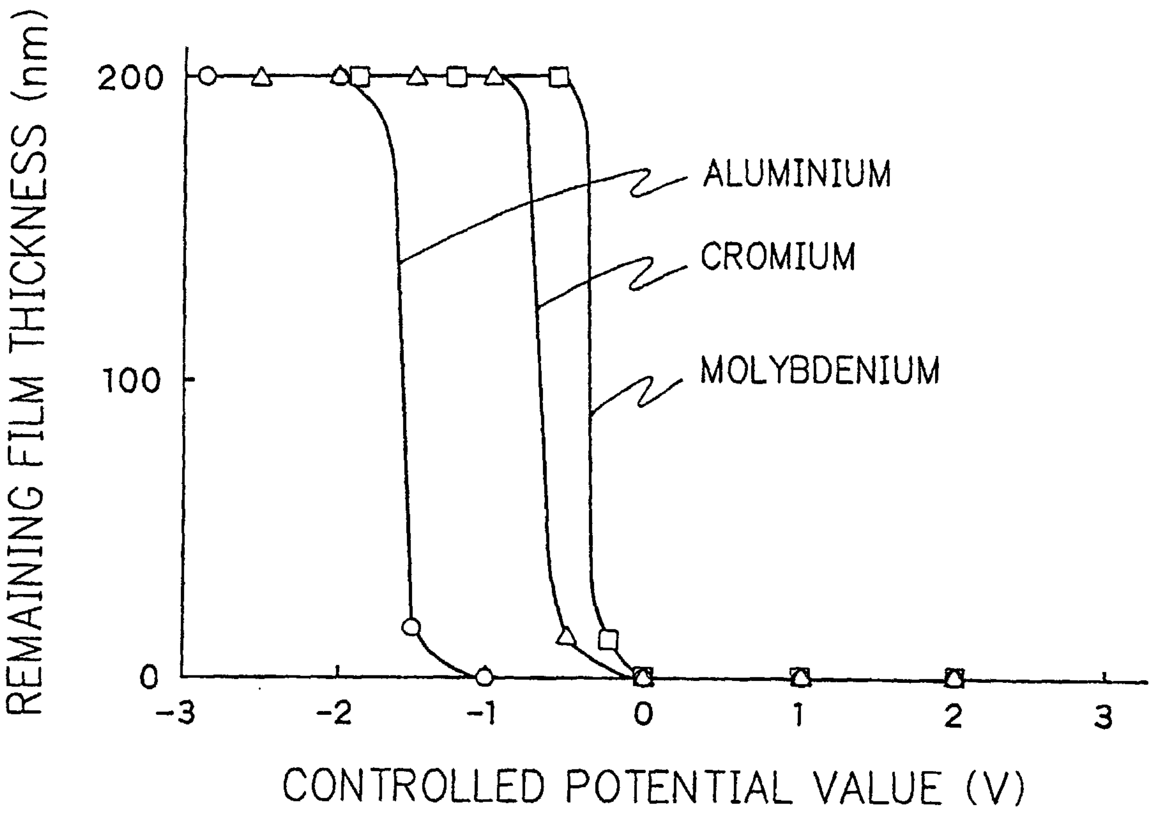
REMAINING FILM THICKNESS (nm)
200
100
0
-3
-2
-1
0
1
2
3
CONTROLLED POTENTIAL VALUE (V)
ALUMINIUM
CROMIUM
MOLYBDENIUM

FIG. 12(a)

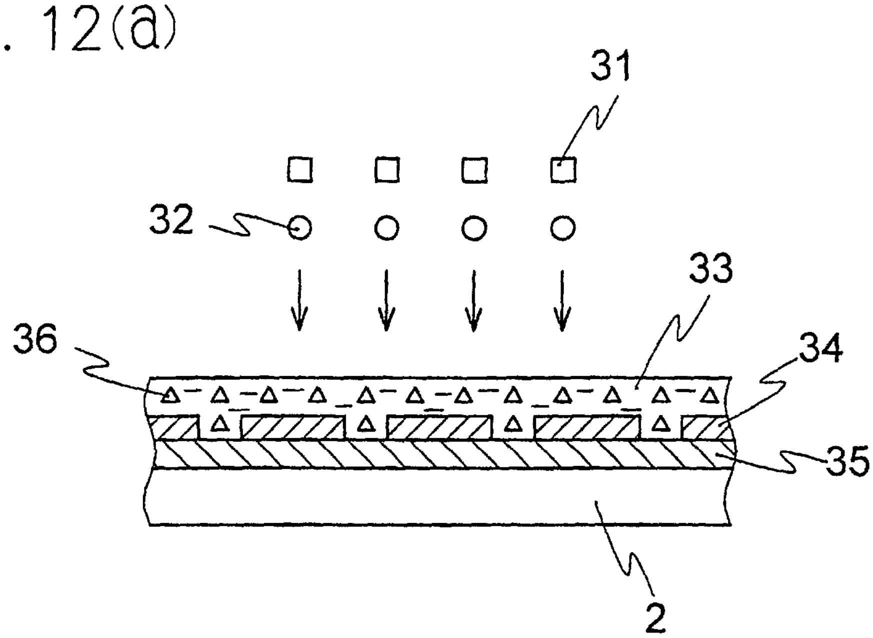


FIG. 12(b)

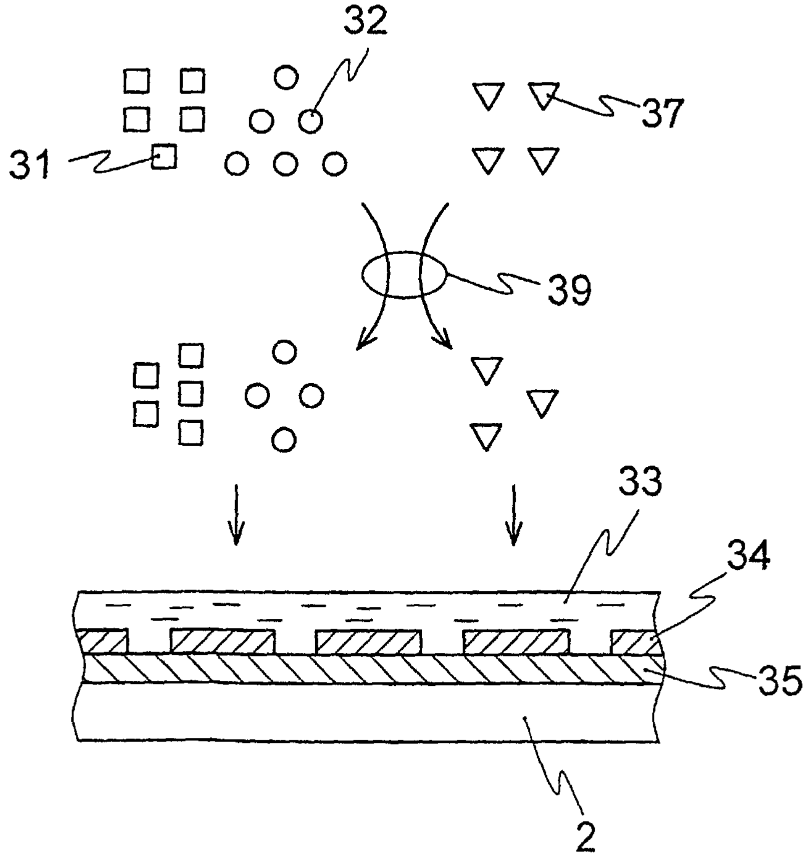

FIG. 13

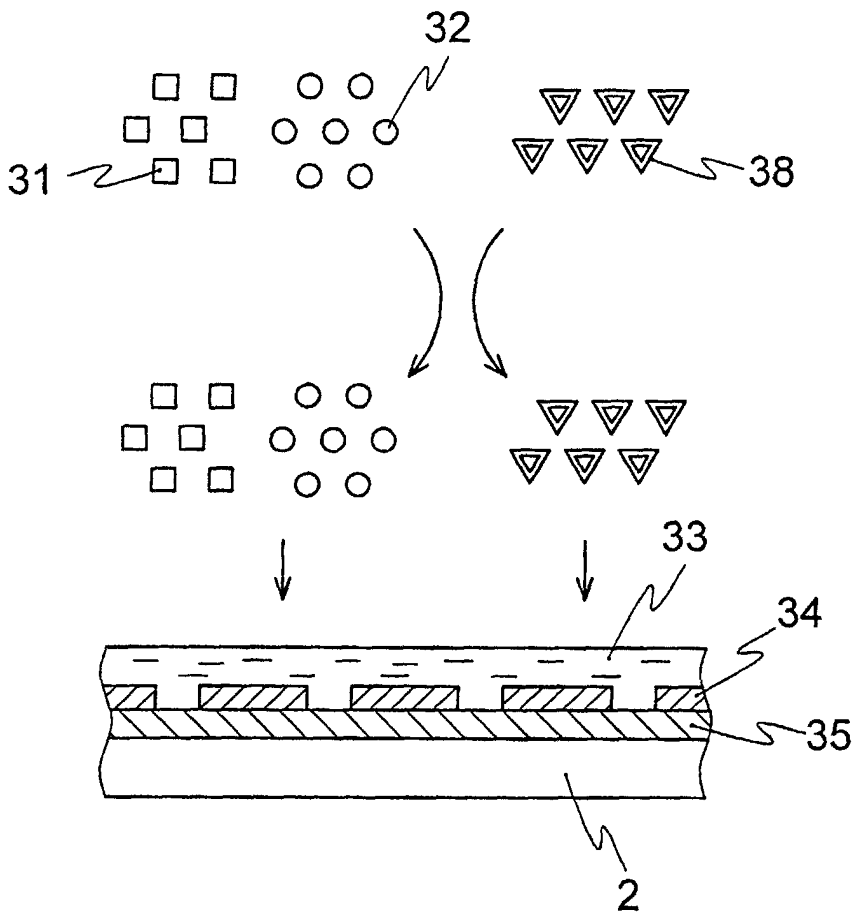

FIG. 14

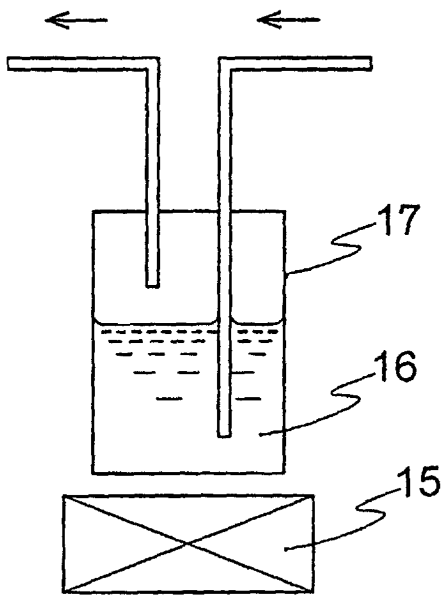


FIG. 15

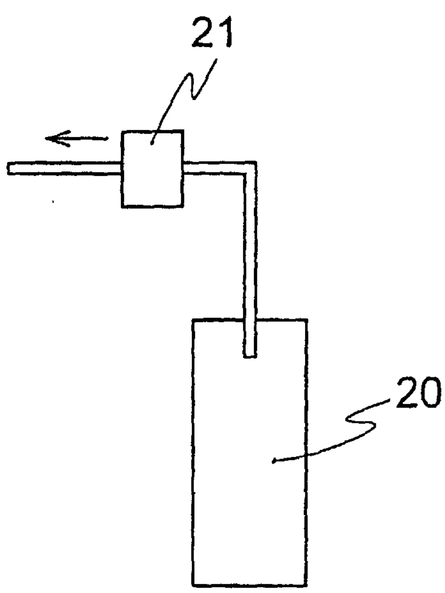

FIG. 16

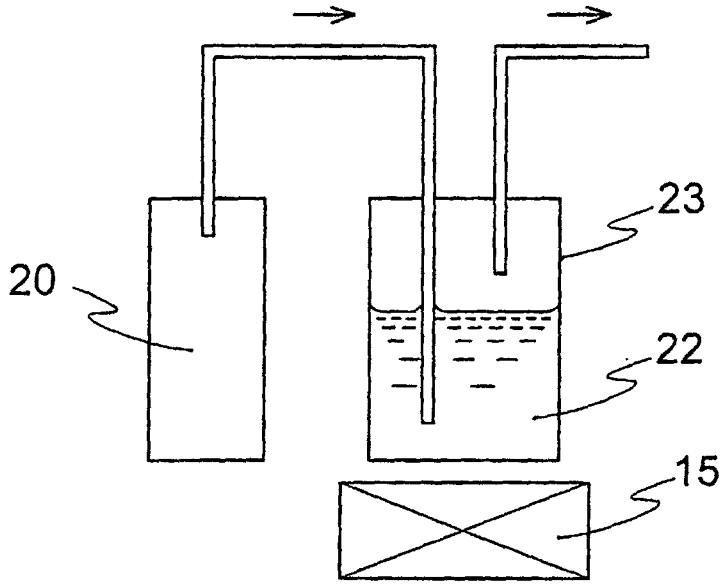


FIG. 17

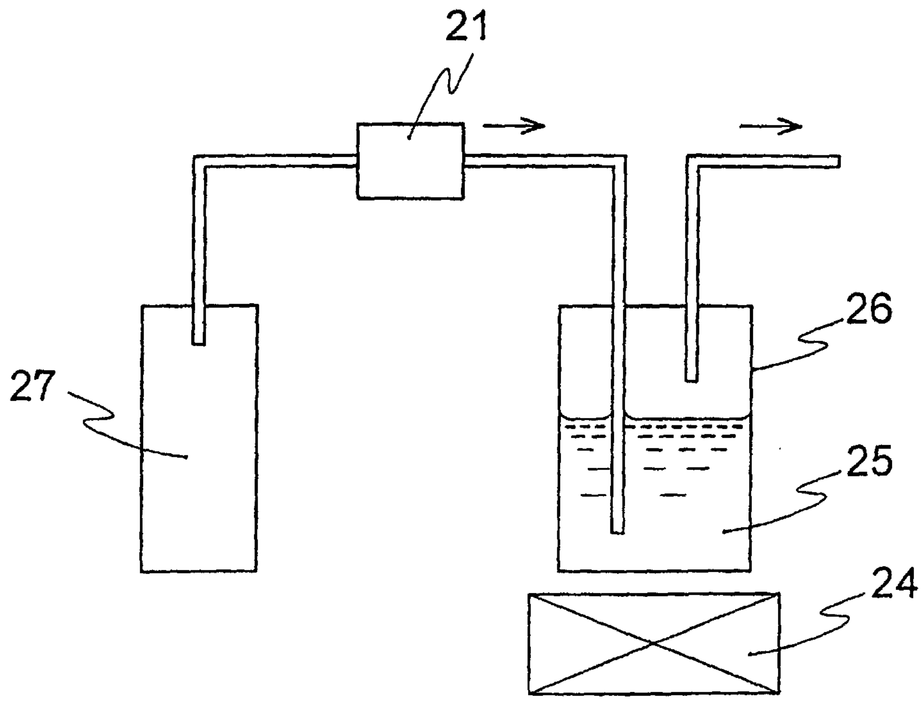

FIG. 18

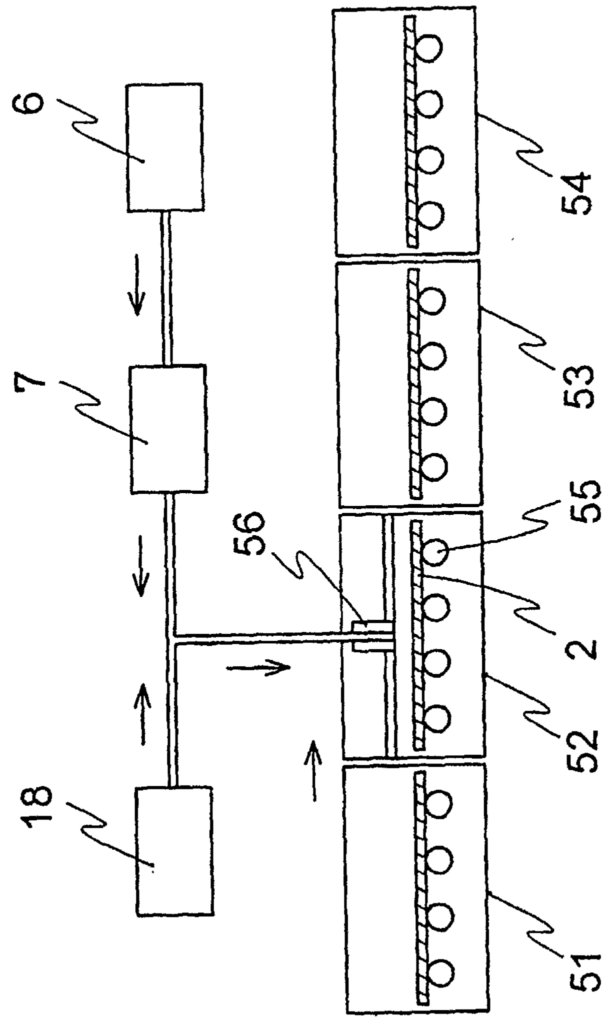

FIG. 19

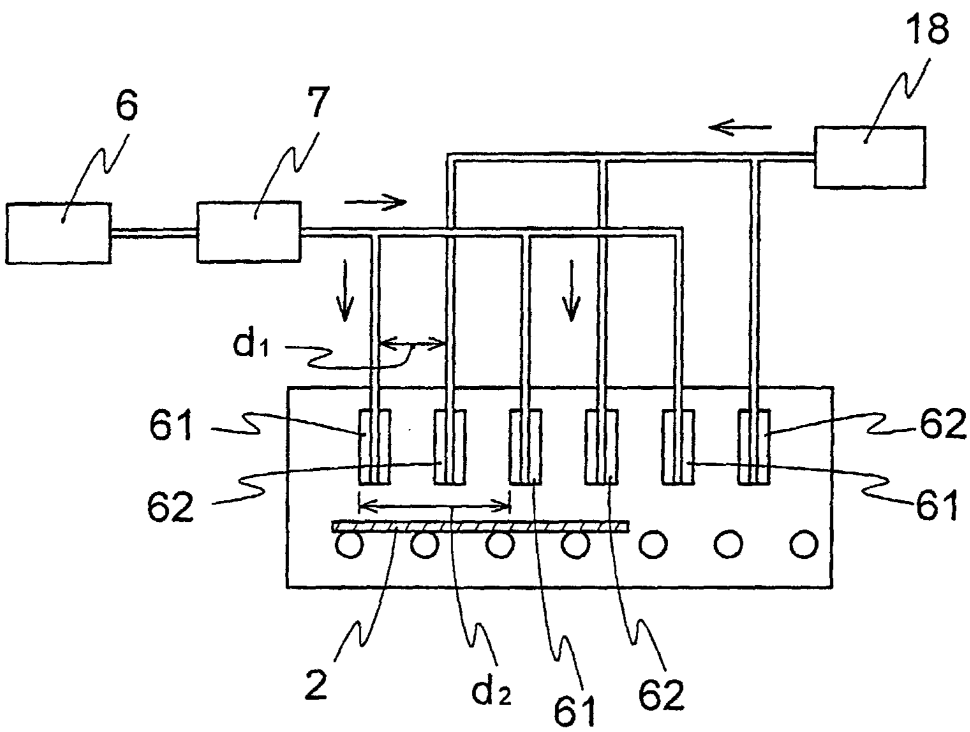

FIG. 20

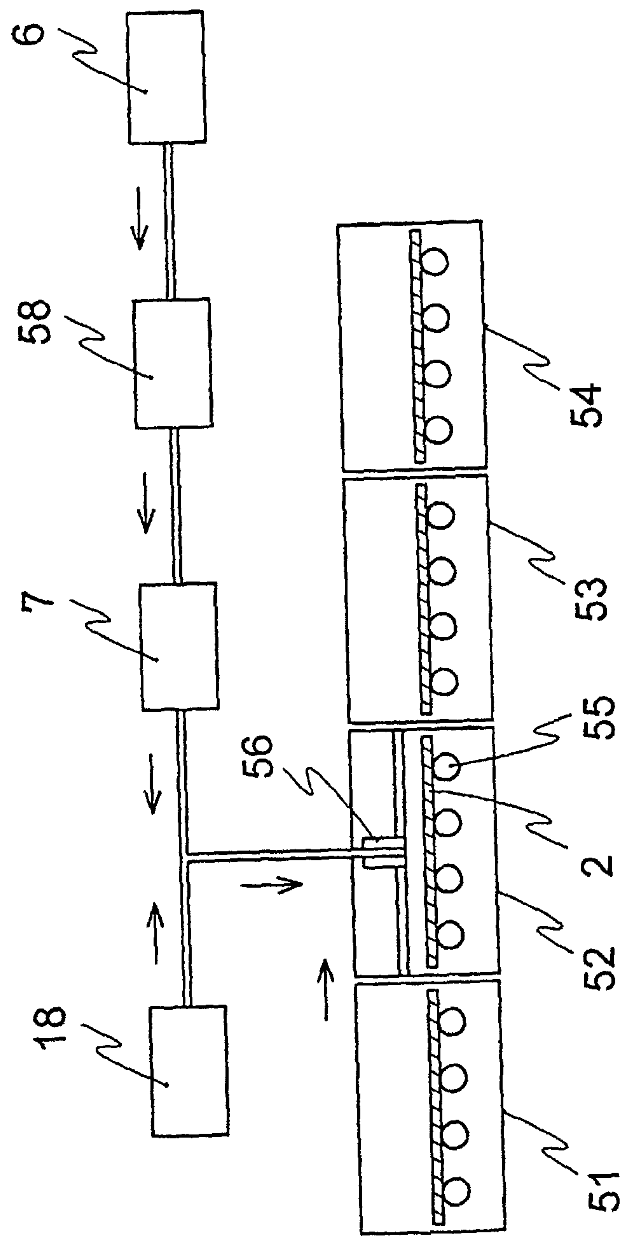

FIG. 21

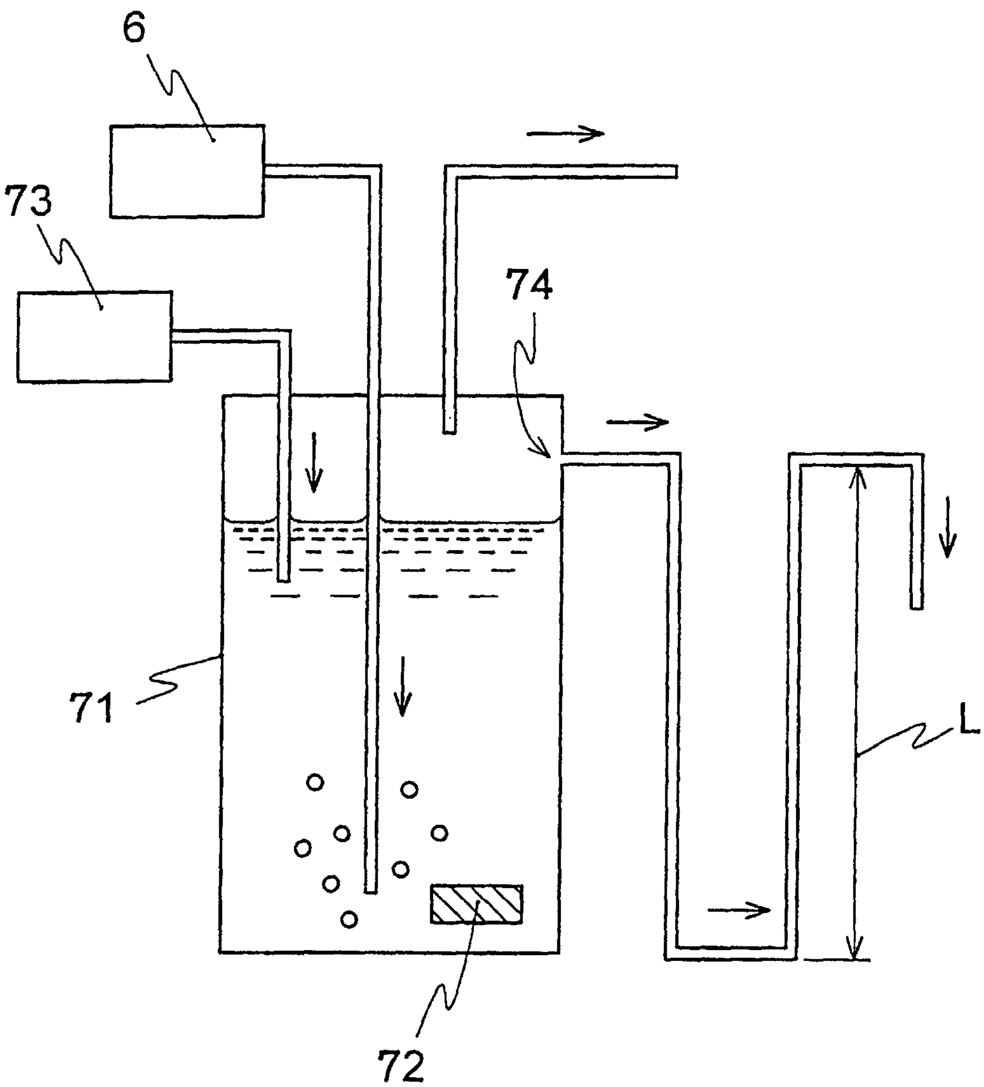

FIG. 22

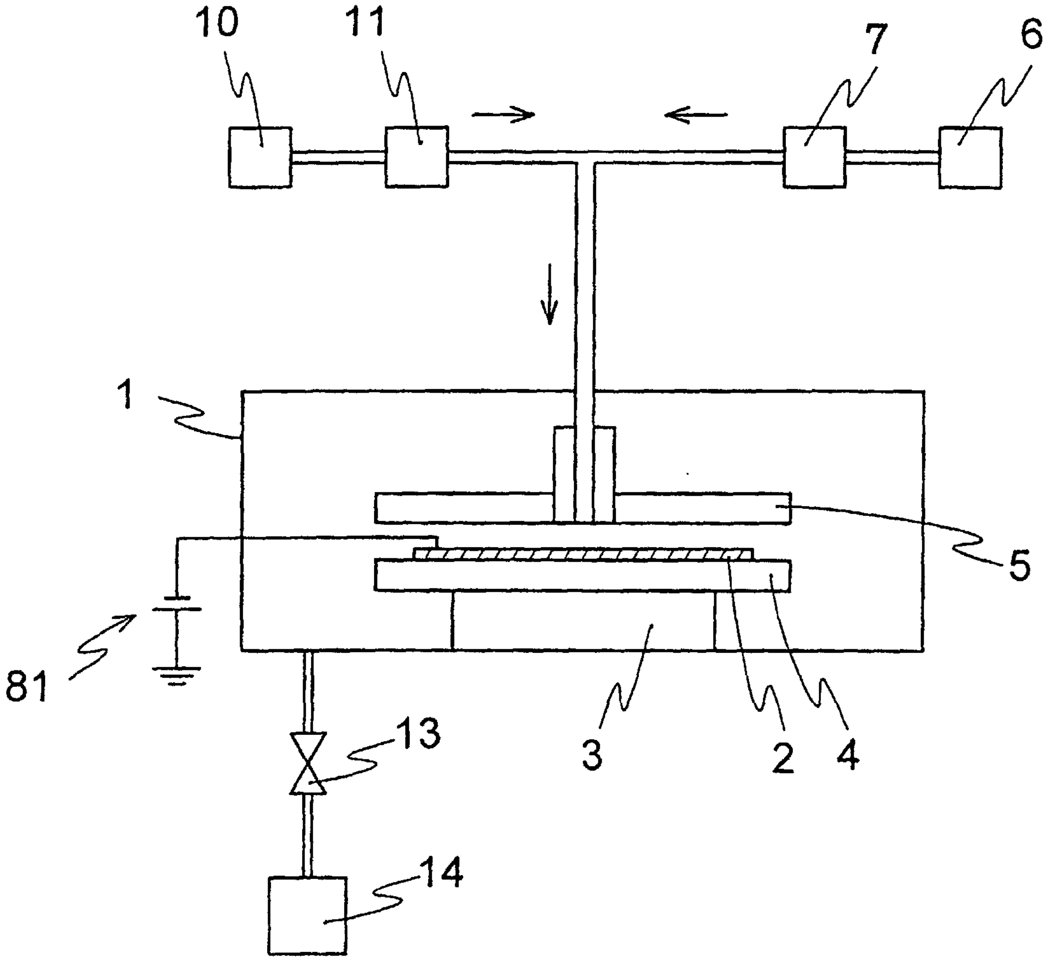

FIG. 23

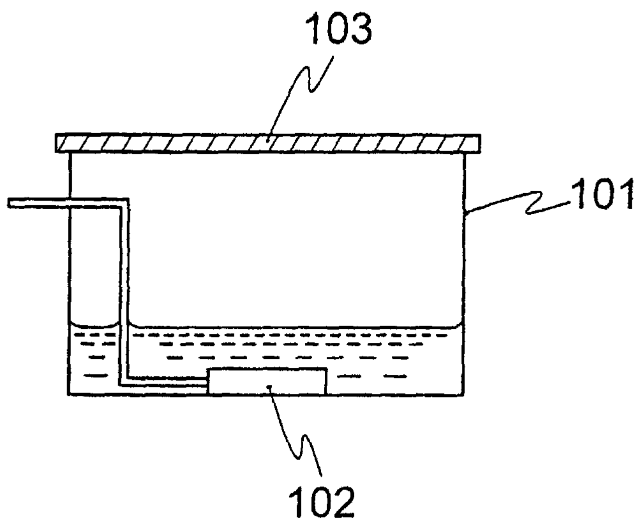


FIG. 24

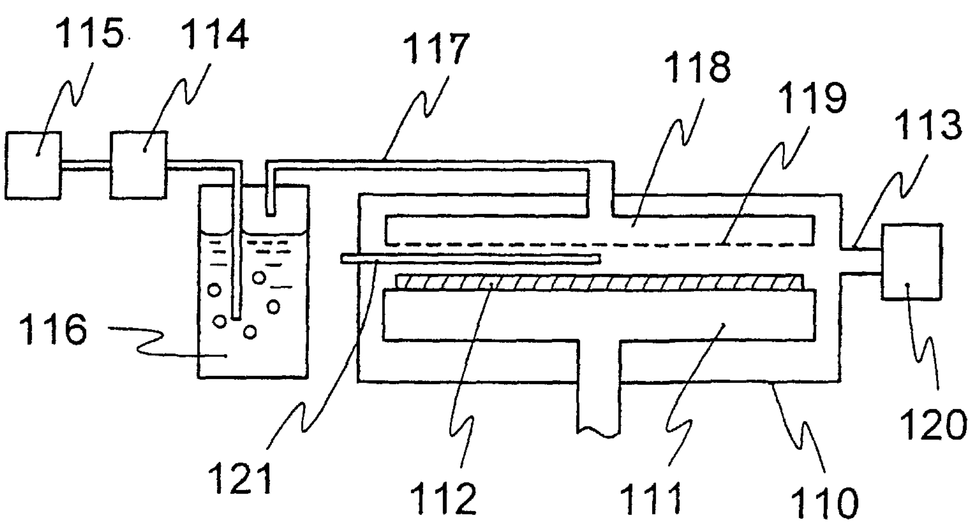

FIG. 25

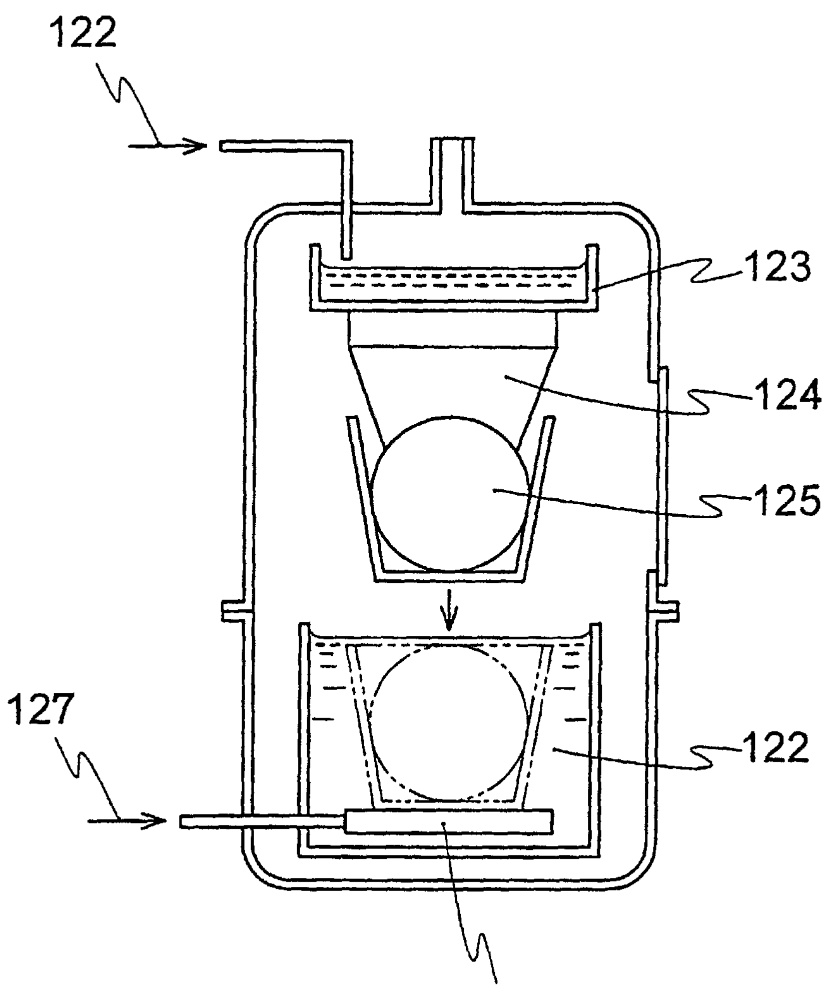

FIG. 26

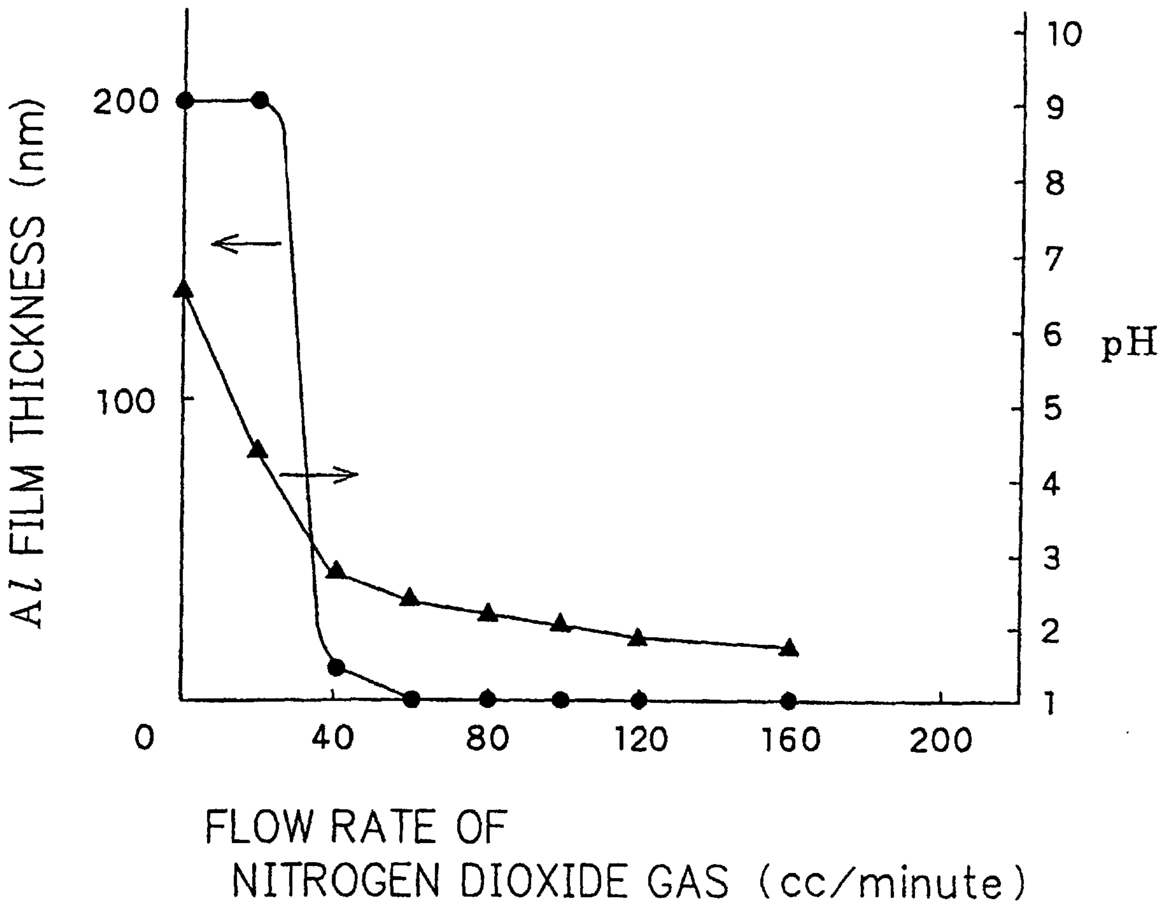
200
100
Al FILM THICKNESS (nm)
10
9
8
7
6
5
4
3
2
1
pH
0
40
80
120
160
200
FLOW RATE OF
NITROGEN DIOXIDE GAS (cc/minute)

## INTERNATIONAL SEARCH REPORT

International application No.
PCT/JP01/04962

**A. CLASSIFICATION OF SUBJECT MATTER**
Int.Cl[7] H01L21/304, H01L21/306, B08B3/10

According to International Patent Classification (IPC) or to both national classification and IPC

**B. FIELDS SEARCHED**

Minimum documentation searched (classification system followed by classification symbols)
Int.Cl[7] H01L21/304, H01L21/306, B08B3/10, H01L21/027

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2001 |
| Kokai Jitsuyo Shinan Koho | 1971-2001 | Jitsuyo Shinan Toroku Koho | 1996-2001 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2000-150349 A (Mitsubishi Electric Corporation), 30 May, 2000 (30.05.00), Par. No. [0027]; Figs. 1 to 8 & WO 00/30165 A1 & EP 1049142 A | 8-10 |
| A | JP 9-74080 A (Mitsubishi Gas Chemical Company, Inc.), 18 March, 1997 (18.03.97), Full text; Fig. 1 (Family: none) | 1-15 |
| A | JP 5-109686 A (Nippon Steel Corporation), 30 April, 1993 (30.04.93), Full text; Figs. 1 to 2 (Family: none) | 1-15 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>22 August, 2001 (22.08.01) | Date of mailing of the international search report<br>04 September, 2001 (04.09.01) |
| Name and mailing address of the ISA/<br>Japanese Patent Office | Authorized officer |
| Facsimile No. | Telephone No. |

Form PCT/ISA/210 (second sheet) (July 1992)